# EUROPEAN PATENT APPLICATION

(11) **EP 4 746 244 A1**
(43) Date of publication of application: **20.05.2026**
(21) Application number: 24844197.4
(22) Date of filing: 05.02.2024
(51) Int. Cl.: H02J 9/06, H02B 1/30

(54) **UNINTERRUPTIBLE POWER SUPPLY CABINET**

(30) Priority: 27.07.2023 CN 202322001911 U
(71) Applicant: Huawei Digital Power Technologies Co., Ltd., Shenzhen, Guangdong 518043 (CN)
(72) Inventor: LIANG, Xianguang, Shenzhen, Guangdong 518043 (CN); LI, Haizhou, Shenzhen, Guangdong 518043 (CN); WANG, Huanyu, Shenzhen, Guangdong 518043 (CN)
(74) Representative: Maiwald GmbH
(86) International application number: PCT/CN2024/076129
(87) International publication number: WO 2025/020498

(57) **Abstract**

Embodiments of this application provide an uninterruptible power supply cabinet. The uninterruptible power supply cabinet includes a cabinet body, a switch component, and a power cabinet. The cabinet body is provided with an external port and a first power connection end, and the external port is configured to connect to an external device. The switch component is disposed in the cabinet body, one end of the switch component is electrically connected to the external port, and another end of the switch component is electrically connected to the first power connection end. The power cabinet is disposed in the cabinet body, and the power cabinet includes a first frame and at least one power module. The first frame includes a second power connection end, and the second power connection end is configured to detachably and electrically connect to the first power connection end. The power module is detachably mounted on the first frame, and the power module is detachably and electrically connected to the second power connection end. The uninterruptible power supply cabinet can replace a component that cannot be replaced in the past in the cabinet, thereby improving maintenance convenience and system reliability.

## Description

### CROSS-REFERENCE TO RELATED APPLICATIONS

This application claims priority to Chinese Patent Application No. 202322001911.3, filed with the China National Intellectual Property Administration on July 27, 2023 and entitled "UNINTERRUPTIBLE POWER SUPPLY CABINET", which is incorporated herein by reference in its entirety.

### TECHNICAL FIELD

This application relates to the field of power supply technologies, and in particular, to an uninterruptible power supply cabinet.

### BACKGROUND

An uninterruptible power supply (uninterruptible power supply, UPS) system is a power supply device for supplying power to a load. An input end of the uninterruptible power supply system may be connected to a mains power supply, and an output end of the uninterruptible power supply system is connected to the load. In normal cases, power is supplied to the load through the mains power supply. When the mains power supply is abnormal, the uninterruptible power supply system uses a battery as backup power to supply power to the load, to ensure uninterruptible power supplying.

Currently, a basic structure of the uninterruptible power supply system may be centralized in a cabinet. However, some structures of an existing uninterruptible power supply system are integrated with the cabinet. When these structures are faulty and need to be replaced or maintained, the cabinet needs to be dragged out for operation, resulting in a difficulty in maintenance. In some scenarios in which the cabinet cannot be dragged out, these structures cannot be maintained basically.

### SUMMARY

Embodiments of this application provide an uninterruptible power supply cabinet. The uninterruptible power supply cabinet can replace a component that cannot be replaced in the past in the cabinet, thereby improving maintenance convenience and system reliability.

According to a first aspect, an uninterruptible power supply cabinet is provided. The uninterruptible power supply cabinet may be used in an indoor scenario such as a data center, and is configured to convert supplied power into a stable and reliable power source for output. The uninterruptible power supply cabinet includes a cabinet body, a switch component, and a power cabinet. The cabinet body has an accommodation cavity that can be used to accommodate the power cabinet and the switch component. The cabinet body is provided with an external port and a first power connection end, and the external port is configured to connect to an external device such as a power supply or a load. The switch component is disposed in the cabinet body, one end of the switch component is electrically connected to the external port, and another end of the switch component is electrically connected to the first power connection end. The power cabinet is disposed in the cabinet body, and the power cabinet includes a first frame and at least one power module. The first frame includes a second power connection end, and the second power connection end is configured to detachably and electrically connect to the first power connection end. The power module is detachably mounted on the first frame, and the power module is detachably and electrically connected to the second power connection end.

According to the uninterruptible power supply cabinet provided in this application, the power cabinet and the cabinet body can be detached from each other, and the second power connection end and the first power connection end can form an electrical connection breakpoint between the power cabinet and the cabinet body. When the first frame of the power cabinet is mounted in the cabinet body, the second power connection end and the first power connection end can be in contact to implement an electrical connection. When the first frame of the power cabinet is removed out of the cabinet body, the second power connection end may be disconnected from the first power connection end. For the entire uninterruptible power supply cabinet, the power module can implement 1-level replacement, and a power distribution device that is on the power cabinet and that is used to connect the power module and the switch component can implement 2-level replacement together with removal of the first frame. Compared with the conventional technology, in this application, power distribution devices, such as a copper bar and a cable, that cannot be usually replaced in the past may be detached and removed for maintenance. This improves maintenance convenience, and can improve system reliability.

In a possible implementation, the power cabinet includes a bypass module, where the bypass module is detachably mounted on the first frame, and the bypass module is detachably and electrically connected to the second power connection end. A power distribution device that is on the first frame of the power cabinet and that is used to connect the bypass module and the switch component can implement 2-level replacement through removal of the first frame.

In a possible implementation, the power cabinet includes a control module, where the control module is detachably mounted on the first frame, and the control module is separately signal-connected to the power module and the bypass module. When the control module is connected to the power module and the bypass module in a wired manner, power distribution devices between the control module and the power module and between the control module and the bypass module are mounted on the first frame, and the power distribution devices between the control module and the power module and between the control module and the bypass module can implement 2-level replacement through removal of the first frame.

In a possible implementation, the uninterruptible power supply cabinet includes a control cabinet, where the control cabinet includes a third frame and a control module, the control module is detachably mounted on the third frame, and the control module is signal-connected to each power module. When the control module is connected to the power module in a wired manner, at least a part of power distribution devices between the control module and the power module are mounted on the first frame and the third frame, and the part of power distribution devices between the control module and the power module and the bypass module can implement 2-level replacement through removal of the first frame and the third frame.

In a possible implementation, the uninterruptible power supply cabinet includes a bypass cabinet, where the bypass cabinet includes a second frame and a bypass module. The cabinet body includes a first bypass connection end, the second frame includes a second bypass connection end, and the second bypass connection end is configured to detachably and electrically connect to the first bypass connection end. The second bypass connection end and the first bypass connection end can form an electrical connection breakpoint between the bypass cabinet and the cabinet body. The bypass module is detachably mounted on the second frame, and the bypass module is detachably and electrically connected to the second bypass connection end. Therefore, a power distribution device that is on the bypass cabinet and that is used to connect the bypass module and the switch component can implement 2-level replacement together with removal of the second frame.

When the uninterruptible power supply cabinet includes the control cabinet, the control cabinet includes the third frame and the control module, the control module is detachably mounted on the third frame, and the control module is signal-connected to each power module.

In a possible implementation, the bypass cabinet includes a control module, where the control module is detachably mounted on the second frame, and the control module is separately signal-connected to the power module and the bypass module. When the control module is connected to the power module and the bypass module in a wired manner, power distribution devices between the control module and the power module and between the control module and the bypass module are mounted on the second frame, and the power distribution devices between the control module and the power module and between the control module and the bypass module can implement 2-level replacement through removal of the second frame.

In a possible implementation, the switch component is integrated into the bypass cabinet. The first power connection end is fastened to the second frame, the switch component is detachably mounted on the second frame, and the switch component is detachably and electrically connected to the first power connection end. The cabinet body includes a first switch connection end and a first flat cable connection end, where the first switch connection end is electrically connected to the external port, and the first flat cable connection end is electrically connected to the first power connection end. The second frame includes a second switch connection end, where the second switch connection end is configured to detachably and electrically connect to the first switch connection end, and the switch component is detachably and electrically connected to the second switch connection end. An electrical connection breakpoint between the cabinet body and the second frame is formed between the first switch connection end and the second switch connection end, and an electrical connection breakpoint between the cabinet body and the power cabinet is formed between the first flat cable connection end and the second flat cable connection end. A power distribution device that is on the second frame and that is used to connect the switch component and the external port, and a power distribution device that is on the second frame and that is used to connect the switch component and the power module can implement 2-level replacement through removal of the second frame.

In a possible implementation, the switch component is integrated into the control cabinet. The first power connection end is fastened to the third frame, the switch component is detachably mounted on the third frame, and the switch component is detachably and electrically connected to the first power connection end. The cabinet body includes a first switch connection end and a first flat cable connection end, where the first switch connection end is electrically connected to the external port, and the first flat cable connection end is electrically connected to the first power connection end. The third frame includes a second switch connection end, where the second switch connection end is configured to detachably and electrically connect to the first switch connection end, and the switch component is detachably and electrically connected to the second switch connection end. An electrical connection breakpoint between the cabinet body and the third frame is formed between the first switch connection end and the second switch connection end, and an electrical connection breakpoint between the cabinet body and the power cabinet is formed between the first flat cable connection end and the second flat cable connection end. A power distribution device that is on the third frame and that is used to connect the switch component and the external port, and a power distribution device that is on the third frame and that is used to connect the switch component and the power module can implement 2-level replacement through removal of the third frame.

In a possible implementation, the uninterruptible power supply cabinet includes a switch cabinet, where the switch cabinet includes a fourth frame, and the first power connection end is fastened to the fourth frame. The switch component is detachably mounted on the fourth frame and is detachably and electrically connected to the first power connection end. The cabinet body includes a first switch connection end and a first flat cable connection end, where the first switch connection end is electrically connected to the external port, and the first flat cable connection end is electrically connected to the first power connection end. The fourth frame includes a second switch connection end, where the second switch connection end is configured to detachably and electrically connect to the first switch connection end, and the switch component is detachably and electrically connected to the second switch connection end. An electrical connection breakpoint between the cabinet body and the fourth frame is formed between the first switch connection end and the second switch connection end, and an electrical connection breakpoint between the cabinet body and the power cabinet is formed between the first flat cable connection end and the second flat cable connection end. A power distribution device that is on the fourth frame and that is used to connect the switch component and the external port, and a power distribution device that is on the fourth frame and that is used to connect the switch component and the power module can implement 2-level replacement through removal of the fourth frame.

In a possible implementation, the uninterruptible power supply cabinet includes a connector adapter, where one end of the connector adapter is configured to detachably and electrically connect to the first power connection end, and another end of the connector adapter is configured to detachably and electrically connect to the second power connection end. The connector adapter can further improve maintenance convenience of the system and system reliability.

In a possible implementation, a manner of a connection between the first power connection end and the second power connection end includes any one or a combination of more of a copper bar connection, a fuse connection, a cable connection, and a terminal connection. Specifically, a power distribution device between the power module and a mains input may include a fuse device, and a power distribution device between the power module and a mains output may include a fuse device. A power distribution device between the power module and a battery input may include a copper bar component. A power distribution device between the bypass module and a bypass input may include a copper bar component, and a power distribution device between the bypass module and a bypass output may include a copper bar component.

To facilitate mounting and removal of the power cabinet, a guide rail is disposed in an accommodation cavity of the cabinet body, and the power cabinet is in sliding fit with the guide rail. In addition, a handle is disposed on a surface that is of the first frame and that faces a cabinet door of the cabinet body, and the handle protrudes from the surface that is of the first frame and that faces the cabinet door of the cabinet body.

In a possible implementation, the second power connection end is a plurality of connectors, and the plurality of connectors are arranged at an edge of a top surface of the first frame, to facilitate a connection to the first power connection end in the cabinet body and also facilitate maintenance and replacement.

According to a second aspect, a power supply system is provided. The power supply system includes at least one uninterruptible power supply cabinet provided in the first aspect. When there are a plurality of uninterruptible power supply cabinets, the plurality of uninterruptible power supply cabinets may be disposed in parallel.

According to a third aspect, a data center is provided. The data center may be replaced with an indoor scenario such as a large communication center, an equipment room of a large-scale enterprise, an equipment room of a financial system, industrial automated equipment, or a scheduling center. The data center includes a power supply, a load, and any uninterruptible power supply cabinet provided in the first aspect or the power supply system provided in the second aspect. The uninterruptible power supply cabinet is connected between the power supply and the load, and is configured to convert electric energy of the power supply into electric energy supplied to the load.

For technical effects that can be achieved in the second aspect and the third aspect, refer to descriptions of technical effects that can be achieved in the corresponding possible design solutions in the first aspect. Details are not described herein again in this application.

### BRIEF DESCRIPTION OF DRAWINGS

FIG. 1 is a schematic of a circuit principle of an uninterruptible power supply cabinet in the conventional technology;
FIG. 2 is a diagram of a structure of an uninterruptible power supply cabinet according to an embodiment of this application;
FIG. 3a is a diagram of a simplified structure of an uninterruptible power supply cabinet according to an embodiment of this application;
FIG. 3b is a diagram of a simplified structure of an uninterruptible power supply cabinet according to an embodiment of this application;
FIG. 3c is a schematic of a circuit principle of an uninterruptible power supply cabinet according to an embodiment of this application;
FIG. 4a is a diagram of a simplified structure of an uninterruptible power supply cabinet according to an embodiment of this application;
FIG. 4b is a schematic of a circuit principle of an uninterruptible power supply cabinet according to an embodiment of this application;
FIG. 5a is a diagram of a simplified structure of an uninterruptible power supply cabinet according to an embodiment of this application;
FIG. 5b is a schematic of a circuit principle of an uninterruptible power supply cabinet according to an embodiment of this application;
FIG. 6a is a diagram of a simplified structure of an uninterruptible power supply cabinet according to an embodiment of this application;
FIG. 6b is a schematic of a circuit principle of an uninterruptible power supply cabinet according to an embodiment of this application;
FIG. 7a is a diagram of a simplified structure of an uninterruptible power supply cabinet according to an embodiment of this application;
FIG. 7b is a schematic of a circuit principle of an uninterruptible power supply cabinet according to an embodiment of this application;
FIG. 8a is a diagram of a simplified structure of an uninterruptible power supply cabinet according to an embodiment of this application;
FIG. 8b is a schematic of a circuit principle of an uninterruptible power supply cabinet according to an embodiment of this application;
FIG. 9a is a diagram of a simplified structure of an uninterruptible power supply cabinet according to an embodiment of this application;
FIG. 9b is a schematic of a circuit principle of an uninterruptible power supply cabinet according to an embodiment of this application;
FIG. 10a is a diagram of a simplified structure of an uninterruptible power supply cabinet according to an embodiment of this application;
FIG. 10b is a schematic of a circuit principle of an uninterruptible power supply cabinet according to an embodiment of this application;
FIG. 11a is a diagram of a simplified structure of an uninterruptible power supply cabinet according to an embodiment of this application;
FIG. 11b is a schematic of a circuit principle of an uninterruptible power supply cabinet according to an embodiment of this application;
FIG. 12a is a diagram of a simplified structure of an uninterruptible power supply cabinet according to an embodiment of this application;
FIG. 12b is a schematic of a circuit principle of an uninterruptible power supply cabinet according to an embodiment of this application;
FIG. 13a is a diagram of a simplified structure of an uninterruptible power supply cabinet according to an embodiment of this application;
FIG. 13b is a schematic of a circuit principle of an uninterruptible power supply cabinet according to an embodiment of this application;
FIG. 14a is a diagram of a simplified structure of an uninterruptible power supply cabinet according to an embodiment of this application;
FIG. 14b is a schematic of a circuit principle of an uninterruptible power supply cabinet according to an embodiment of this application;
FIG. 15a is a diagram of a simplified structure of an uninterruptible power supply cabinet according to an embodiment of this application;
FIG. 15b is a schematic of a circuit principle of an uninterruptible power supply cabinet according to an embodiment of this application;
FIG. 16a is a diagram of a simplified structure of an uninterruptible power supply cabinet according to an embodiment of this application;
FIG. 16b is a schematic of a circuit principle of an uninterruptible power supply cabinet according to an embodiment of this application;
FIG. 17a is a diagram of a simplified structure of an uninterruptible power supply cabinet according to an embodiment of this application;
FIG. 17b is a schematic of a circuit principle of an uninterruptible power supply cabinet according to an embodiment of this application;
FIG. 18a is a diagram of a simplified structure of an uninterruptible power supply cabinet according to an embodiment of this application;
FIG. 18b is a schematic of a circuit principle of an uninterruptible power supply cabinet according to an embodiment of this application;
FIG. 19a is a diagram of a simplified structure of an uninterruptible power supply cabinet according to an embodiment of this application;
FIG. 19b is a schematic of a circuit principle of an uninterruptible power supply cabinet according to an embodiment of this application;
FIG. 20a is a diagram of a simplified structure of an uninterruptible power supply cabinet according to an embodiment of this application;
FIG. 20b is a schematic of a circuit principle of an uninterruptible power supply cabinet according to an embodiment of this application;
FIG. 21a is a diagram of a simplified structure of an uninterruptible power supply cabinet according to an embodiment of this application;
FIG. 21b is a schematic of a circuit principle of an uninterruptible power supply cabinet according to an embodiment of this application;
FIG. 22a is a diagram of a simplified structure of an uninterruptible power supply cabinet according to an embodiment of this application;
FIG. 22b is a schematic of a circuit principle of an uninterruptible power supply cabinet according to an embodiment of this application;
FIG. 23a is a diagram of a simplified structure of an uninterruptible power supply cabinet according to an embodiment of this application;
FIG. 23b is a schematic of a circuit principle of an uninterruptible power supply cabinet according to an embodiment of this application;
FIG. 24 is a diagram of a structure of an uninterruptible power supply cabinet according to an embodiment of this application;
FIG. 25a is a diagram of a structure of a cabinet body of an uninterruptible power supply cabinet according to an embodiment of this application;
FIG. 25b is a diagram of a structure of a first frame of an uninterruptible power supply cabinet according to an embodiment of this application;
FIG. 25c is a diagram of structures of a power module and a bypass module of an uninterruptible power supply cabinet according to an embodiment of this application;
FIG. 25d is a diagram of a structure of a control cabinet of an uninterruptible power supply cabinet according to an embodiment of this application; and
FIG. 26 is a diagram of a structure of a data center according to an embodiment of this application.

### DESCRIPTION OF EMBODIMENTS

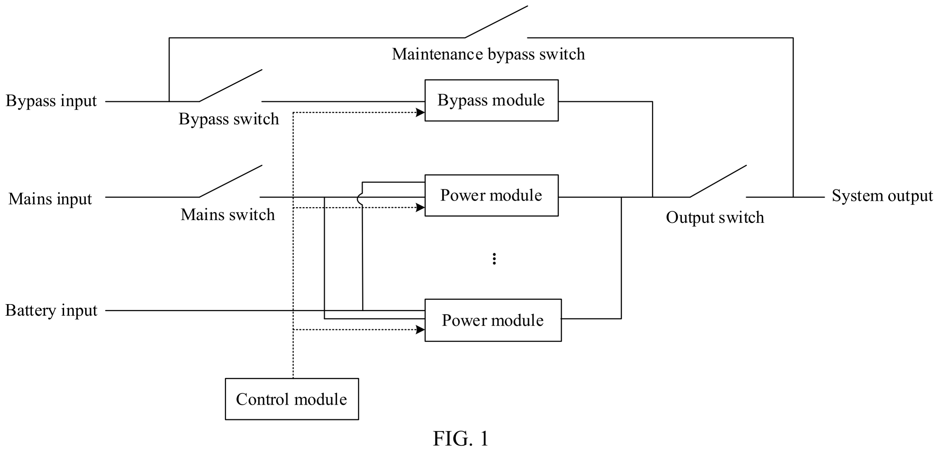

FIG. 1 is a schematic of a circuit principle of an uninterruptible power supply system. As shown in FIG. 1, the uninterruptible power supply system is used as a power supply device. An input side of the uninterruptible power supply system is connected to a power supply through a mains switch, to convert supplied power into a stable and reliable power source for output. An output side of the uninterruptible power supply is connected to a load through an output switch. When a mains power supply is abnormal, the uninterruptible power supply device uses a battery as backup power and converts the backup power into an output, to supply a continuous and uninterruptible power source to the load. The uninterruptible power supply system includes a control module, a power module, and a bypass module, and is provided with a circuit component connected to these modules. When the power module is faulty, a bypass input supplies power to the load through a bypass switch, the bypass module, and an output switch. The control module controls switching in the foregoing cases. A maintenance bypass switch may be turned on when the power module or the bypass module needs to be maintained. The mains switch, the bypass switch, the output switch, and the maintenance bypass switch can be internally disposed in the uninterruptible power supply system or externally disposed in a power distribution cabinet. When the uninterruptible power supply system is faulty, all external switches usually need to be turned off and then a cabinet is dragged out for replacement or maintenance. As a result, maintenance time is long, and maintenance is more difficult in a scenario in which the cabinet cannot be dragged out.

In view of this, embodiments of this application provide an uninterruptible power supply cabinet, a power supply system, and a data center. Functional modules in the uninterruptible power supply cabinet can implement replacement of the functional modules and power distribution devices, thereby improving maintenance convenience and system reliability.

To make objectives, technical solutions, and advantages of this application clearer, the following further describes this application in detail with reference to accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include specific features, structures, or features described with reference to embodiments. Therefore, statements such as "in one embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "contain", "have", and variants thereof all mean "include but are not limited to", unless otherwise specifically emphasized in another manner.

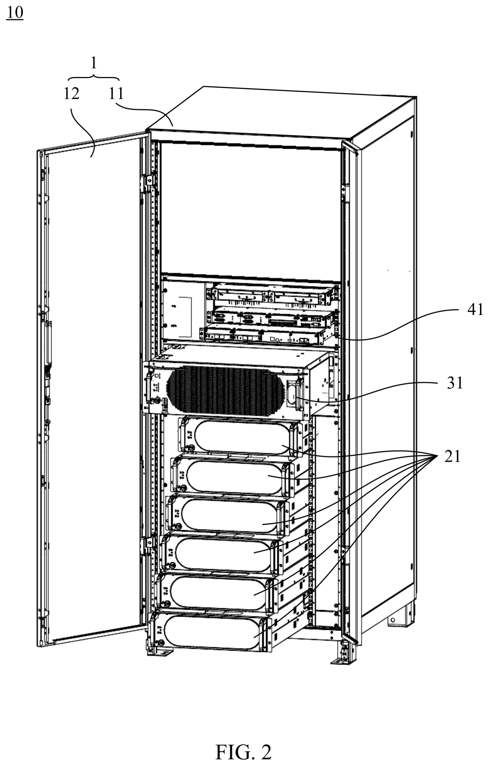

FIG. 2 shows an uninterruptible power supply cabinet 10 according to an embodiment of this application, including a cabinet body 1, a power module 21, a bypass module 31, and a control module 41. The cabinet body 1 includes a body 11 and a cabinet door 12. The body 11 has an accommodation cavity R. The power module 21, the bypass module 31, and the control module 41 may be accommodated into the accommodation cavity R. The power module 21 may convert an input alternating current or direct current into a stable sine voltage for output. When a mains power supply is abnormal, a system switches to the bypass module 31 to supply power to a load. The control module 41 is configured to systemically collect and control a signal of the uninterruptible power supply cabinet 10. The cabinet door 12 is rotatably mounted at an opening of the accommodation cavity R of the body 11, and the cabinet door 12 can rotate to open or seal the accommodation cavity R of the body 11. FIG. 2 shows an open state of the cabinet door 12. Certainly, the uninterruptible power supply cabinet 10 further includes some surge protection modules, communication modules, or other integrated modules. These modules, the power module 21, the bypass module 31, and the control module 41 each have a hot-swapping replacement function, and can be directly removed for replacement or maintenance during maintenance.

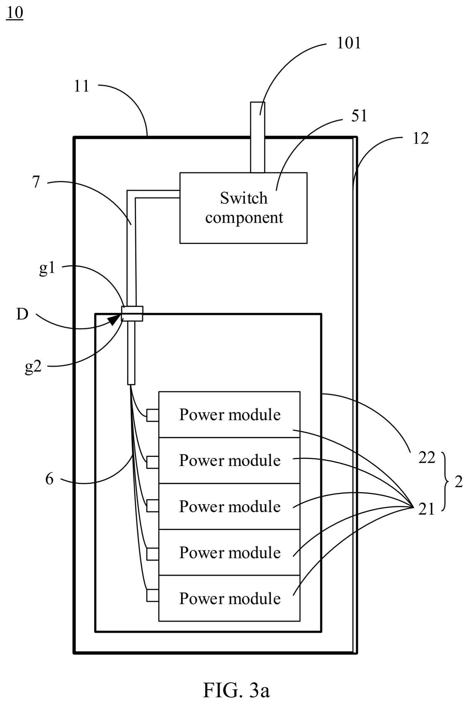

The modules such as the power module 21, the bypass module 31, and the control module 41 are swappable, and are easy to replace or maintain. Some power distribution devices in the uninterruptible power supply cabinet 10 in this embodiment of this application are disposed as replaceable units, to further reduce a maintenance difficulty of the system. Specifically, FIG. 3a is a diagram of a principle and a structure of an uninterruptible power supply cabinet 10. As shown in FIG. 3a, the uninterruptible power supply cabinet 10 has an external port 101 and a first power connection end g1 that are disposed on a body 11 of a cabinet body 1. The external port 101 is, for example, disposed at an upper part in the body 11, and the external port 101 is configured to externally connect to a device such as a power supply or a load. A power cabinet 2 and a switch component 51 are disposed in the cabinet body 1, and the switch component 51 is, for example, disposed above the power cabinet 2. The switch component 51 is an integration of a plurality of isolation switches, and the isolation switch is a mechanical switch device that can meet a specified isolation function requirement when in an off state. The isolation switch can connect and carry a current in a normal circuit condition, and can carry the current in specified time in a non-specified normal circuit condition such as a short circuit. One end of the switch component 51 is electrically connected to the external port 101, and another end of the switch component 51 is connected to the first power connection end g1. Specifically, the switch component 51 may be connected to the first power connection end g1 through a copper bar component 7.

The power cabinet 2 includes a first frame 22 and at least one power module 21. Herein, five power modules 21 are used as an example, and the five power modules 21 are sequentially stacked in a height direction of the cabinet body 1. Each power module 21 is detachably mounted on the first frame 22, so that the power module 21 is detachable relative to the first frame 22 to facilitate replacement and maintenance. The first frame 22 includes a second power connection end g2, and each power module 21 is detachably and electrically connected to the second power connection end g2. When the power module 21 is mounted on the first frame 22 and is located at a mounting position, the power module 21 is electrically connected to the second power connection end g2. When the power module 21 is detached from the first frame 22, the power module 21 is separated from the second power connection end g2. For example, each power module 21 may be detachably connected to the second power connection end g2 through a cable component 6. The second power connection end g2 on the first frame 22 is configured to connect to the first power connection end g1 of the switch component 51. When the first frame 22 of the power cabinet 2 is mounted in the cabinet body 1, the second power connection end g2 and the first power connection end g1 can be in contact to implement an electrical connection. When the first frame 22 of the power cabinet 2 is removed out of the cabinet body 1, the second power connection end g2 may be disconnected from the first power connection end g1.

It can be seen from FIG. 3a that, an electrical connection breakpoint between the power cabinet 2 and the cabinet body 1 may be formed between the second power connection end g2 and the first power connection end g1, so that the first frame 22 of the power cabinet 2 can be detachably removed out of the cabinet body 1, and the second power connection end g2, the cable component 6, and other power distribution devices, that are on the first frame 22 can be removed out of the cabinet body 1 together with the first frame 22. In this case, these power distribution devices may be maintained. In addition, the power module 21 that is detachably mounted on the first frame 22 may also be detached and removed out of the first frame 22. For the entire uninterruptible power supply cabinet 10, the power module 21 can implement 1-level replacement, and the power distribution device on the power cabinet 2 can implement 2-level replacement. Compared with the conventional technology, in this application, power distribution devices, such as a copper bar and a cable, that cannot be usually replaced in the past may be detached and removed for maintenance. This improves maintenance convenience, can improve system reliability, and also can shorten maintenance time.

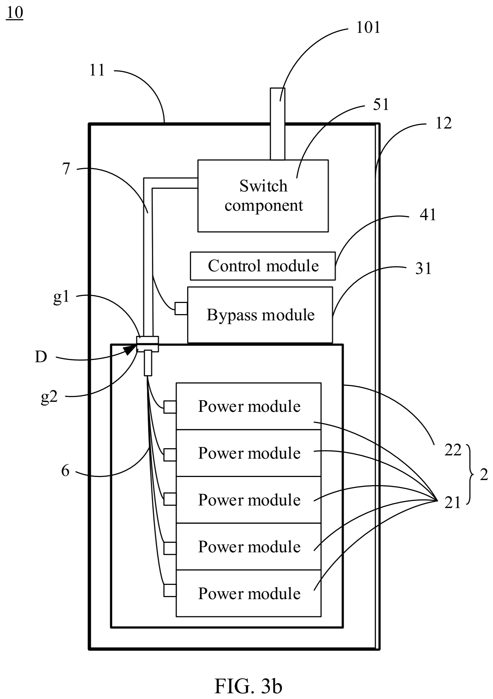

Certainly, the uninterruptible power supply cabinet 10 further includes a bypass module 31 and a control module 41. In an uninterruptible power supply cabinet 10 shown in FIG. 3b, a bypass module 31 and a control module 41 are disposed between a switch component 51 and a power cabinet 2. The control module 41 is separately signal-connected to each power module 21 and the bypass module 31.

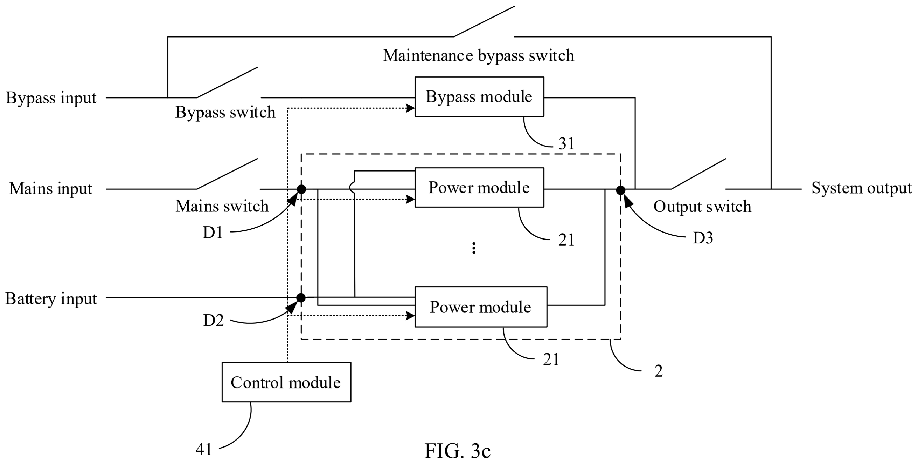

FIG. 3c is a schematic of a circuit principle of the uninterruptible power supply cabinet 10 shown in FIG. 3b. As shown in FIG. 3c, the uninterruptible power supply cabinet 10 has an input end and an output end that are integrated into an external port 101, where the input end is configured to connect to a power supply, and the power supply specifically includes a bypass input, a mains input, and a battery input. The output end is configured to connect to the load, and an uninterruptible power supply network is formed between the input end and the output end, and is configured to convert electric energy input from the input end, and then supply converted electric energy to the load through the output end for use. A plurality of power modules 21 are connected in parallel to form a power module component, the power module component is separately connected to the mains input and the battery input, and an output side of the power module component is connected to the output end. An output side of the bypass module 31 is connected in parallel to the output side of the power module component and then connected to the output end. The switch component 51 specifically includes a mains switch, a bypass switch, an output switch, and a maintenance bypass switch. The mains switch is disposed between the mains input and the power module, the bypass switch is disposed between the bypass input and the bypass module 31, the output switch is disposed between the output end and a node formed by connecting the output side of the power module component in parallel to the output side of the bypass module 31, and the maintenance bypass switch is disposed between the bypass input and the output end. Breakpoints D formed between the first power connection end g1 of the cabinet body 1 and the second power connection end g2 of the power cabinet 2 are distributed at a plurality of positions, and specifically include a breakpoint D1 between the mains switch and the power module component formed by connecting the plurality of power modules 21 in parallel, a breakpoint D2 between the battery input and the power module component formed by connecting the plurality of power modules 21 in parallel, and a breakpoint D3 between the output switch and the power module component formed by connecting the plurality of power modules 21 in parallel. When the power cabinet 2 is mounted in the cabinet 1, all the breakpoints D may be connected, so that each power module 21 can be connected to the power supply network. When the power cabinet 2 is removed out of the cabinet 1, all the breakpoints D may be disconnected.

For example, the breakpoint D1 between the mains switch and the power module component formed by connecting the plurality of power modules 21 in parallel may be detachably connected through a fuse device, and the breakpoint D3 between the output switch and the power module component formed by connecting the plurality of power modules 21 in parallel may be detachably connected through a fuse device, thereby enhancing circuit reliability. The breakpoint D2 between the battery input and the power module component formed by connecting the plurality of power modules 21 in parallel may be detachably connected through a copper bar component.

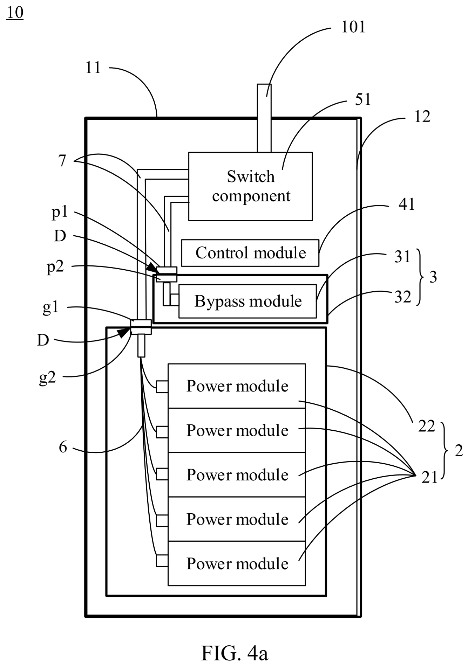

Based on the uninterruptible power supply cabinet 10 shown in FIG. 3b, an uninterruptible power supply cabinet 10 shown in FIG. 4a includes a bypass cabinet 3 disposed in a cabinet body 1. For example, the bypass cabinet 3 is disposed between a control module 41 and a power cabinet 2. The bypass cabinet 3 includes a second frame 32 and a bypass module 31 detachably mounted on the second frame 32. A difference from the structure shown in FIG. 3b lies in that, the bypass module 31 in FIG. 4a is detachably mounted on the second frame 32 of the bypass cabinet 3, so that the bypass module 31 is detachable relative to the second frame 32 to facilitate replacement and maintenance. The cabinet body 1 is further provided with a first bypass connection end p1. Specifically, a switch component 51 may be connected to the first bypass connection end p1 through a copper bar component 7. The second frame 32 of the bypass cabinet 3 includes a second bypass connection end p2, and the bypass module 31 is detachably and electrically connected to the second bypass connection end p2. When the bypass module 31 is mounted on the second frame 32 and is located at a mounting position, the bypass module 31 is electrically connected to the second bypass connection end p2. When the bypass module 31 is detached from the second frame 32, the bypass module 31 is separated from the second bypass connection end p2. For example, the bypass module 31 may be detachably connected to the second bypass connection end p2 through a cable component or another power distribution device. The second bypass connection end p2 on the second frame 32 is configured to connect to the first bypass connection end p1 of the cabinet body 1. When the second frame 32 of the bypass cabinet 3 is mounted in the cabinet body 1, the second bypass connection end p2 and the first bypass connection end p1 can be in contact to implement an electrical connection. When the second frame 32 of the bypass cabinet 3 is removed out of the cabinet body 1, the second bypass connection end p2 may be disconnected from the first bypass connection end p1.

It can be seen from FIG. 4a that, an electrical connection breakpoint between the bypass cabinet 3 and the cabinet body 1 may be formed between the second bypass connection end p2 and the first bypass connection end p1, so that the second frame 32 of the bypass cabinet 3 can be detachably removed out of the cabinet body 1, and the second bypass connection end p2 and other power distribution devices that are included in the second frame 32 can be removed out of the cabinet body 1 together with the second frame 32. In this case, these power distribution devices may be maintained. In addition, the bypass module 31 that is detachably mounted on the second frame 32 may also be detached and removed out of the second frame 32. For the entire uninterruptible power supply cabinet 10, the bypass module 31 can implement 1-level replacement, and the power distribution device on the second frame 32 of the bypass cabinet 3 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

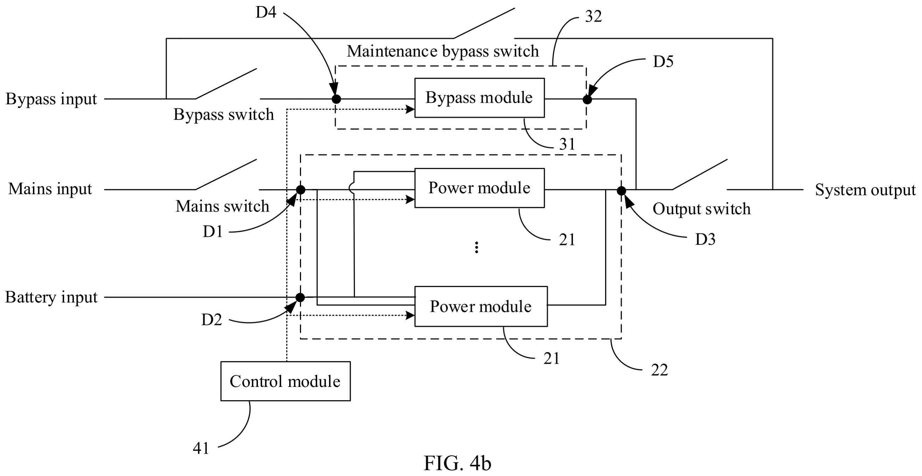

FIG. 4b is a schematic of a circuit principle of the uninterruptible power supply cabinet 10 shown in FIG. 4a. As shown in FIG. 4b, breakpoints D formed between the first bypass power connection end p1 of the cabinet body 1 and the second bypass connection end p1 of the bypass cabinet 3 are distributed at two positions, and specifically include a breakpoint D4 between the bypass switch and the bypass module 31 and a breakpoint D5 between the bypass module 31 and the output switch. When the bypass cabinet 3 is mounted in the cabinet 1, all the breakpoints D may be connected, so that the bypass module 31 can be connected to the power supply network. When the bypass cabinet 3 is removed out of the cabinet 1, all the breakpoints D may be disconnected. The breakpoint D formed between the first power connection end g1 of the cabinet body 1 and the second power connection end g2 of the power cabinet 2 is similar to that in FIG. 3c, and details are not described herein again.

For example, the breakpoint D4 between the bypass module 31 and the bypass switch may be detachably connected through a copper bar component, and the breakpoint D5 between the bypass module 31 and the output switch may be detachably connected through a copper bar component.

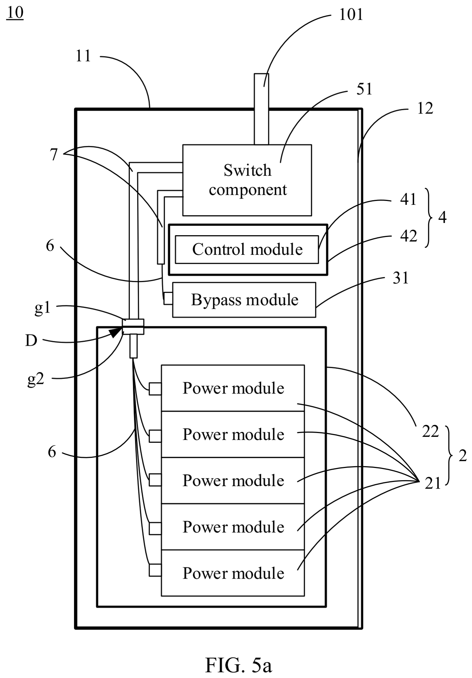

In some embodiments, based on the uninterruptible power supply cabinet 10 shown in FIG. 3b, an uninterruptible power supply cabinet 10 shown in FIG. 5a includes a control cabinet 4 disposed in a cabinet body 1. For example, the control cabinet 4 is disposed at a top of a bypass module 31. The control cabinet 4 includes a third frame 42 and a control module 41 detachably mounted on the third frame 42. A difference from the structure shown in FIG. 3b lies in that, the control module 41 is detachably mounted on the third frame 42 of the control cabinet 4, so that the control module 41 is detachable relative to the third frame 42 to facilitate replacement and maintenance.

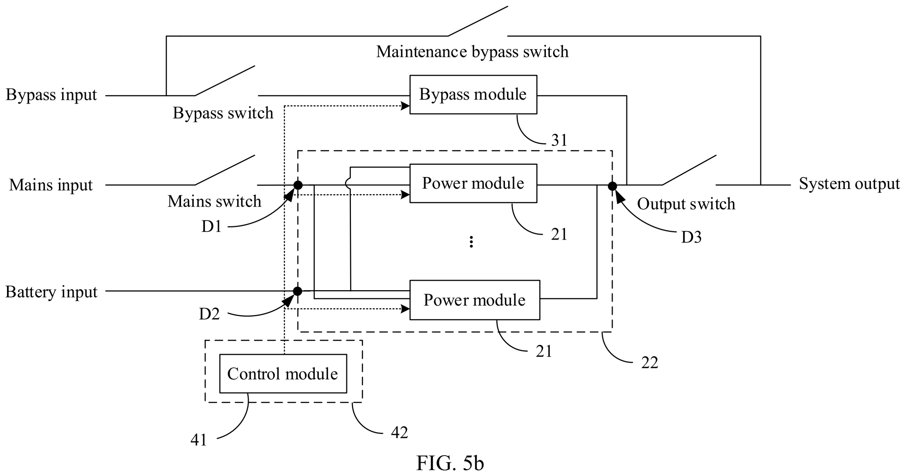

FIG. 5b is a schematic of a circuit principle of the uninterruptible power supply cabinet 10 shown in FIG. 5a. The control module 41 may be signal-connected to the bypass module 31 and each power module 21, and may be specifically connected in a wired manner or a wireless manner. Certainly, when the control module 41 is connected to the bypass module 31 and the power module 21 in the wired manner, power distribution devices used to connect the control module 41, the power module 21, and the bypass module 31 may be respectively disposed on the cabinet body 1, a first frame 22, and the third frame 42, and these power distribution devices are detachably and electrically connected. When the control module 41 is mounted on the third frame 42 and is located at a mounting position, the control module 41 can be electrically connected to the bypass module 31 and the power module 21. When the control module 41 is detached from the third frame 42, if the control module 41 is connected to the bypass module 31 and the power module 21 in the wired manner, the control module 41 is detached from the bypass module 31 and the power module 21.

The third frame 42 of the control cabinet 4 can be detachably removed out of the cabinet body 1. In this case, the power distribution device on the third frame 42 may be maintained. In addition, the control module 41 that is detachably mounted on the third frame 42 may also be detached and removed out of the third frame 42. For the entire uninterruptible power supply cabinet 10, the control module 41 can implement 1-level replacement, and the power distribution device on the third frame 42 of the control cabinet 4 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

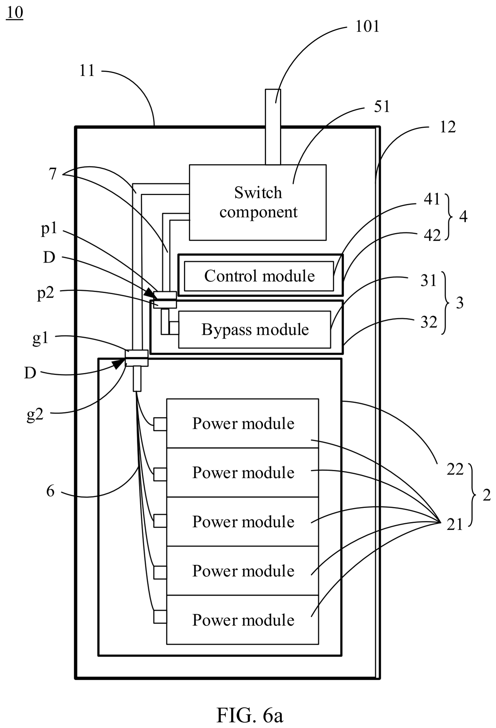

With reference to the structures of the uninterruptible power supply cabinets 10 shown in FIG. 3b, FIG. 4a, and FIG. 5a, FIG. 6a shows a structure of another uninterruptible power supply cabinet 10. As shown in FIG. 6a, the uninterruptible power supply cabinet 10 includes a power cabinet 2, a bypass cabinet 3, and a control cabinet 4. The power cabinet 2 includes a first frame 22 and a plurality of power modules 21 detachably mounted on the first frame 22. The bypass cabinet 3 includes a second frame 32 and a bypass module 31 detachably mounted on the second frame 32. The control cabinet 4 includes a control module 41 detachably mounted on a third frame 42. A cabinet body 1 is provided with a first power connection end g1 and a first bypass connection end p1. One end of a switch component 51 is connected to an external port 101, and another end of the switch component is separately connected to the first power connection end g1 and the first bypass connection end p1 through two copper bar components 7. The first frame 22 is provided with a second power connection end g2 configured to detachably and electrically connect to the first power connection end g1, and the second frame 32 is provided with a second bypass connection end p2 configured to detachably and electrically connect to the first bypass connection end p1. An electrical connection breakpoint D between the cabinet body 1 and the power cabinet 2 is formed between the first power connection end g1 and the second power connection end g2, and an electrical connection breakpoint D between the cabinet body 1 and the bypass cabinet 3 is formed between the first bypass connection end p1 and the second bypass connection end p2. The power module 21 is detachably and electrically connected to the second power connection end g2 through a cable component 6, and the bypass module 31 is detachably and electrically connected to the second bypass connection end p2 through a power distribution device such as a cable component. For the entire uninterruptible power supply cabinet 10, the power module 21, the bypass module 31, and the control module 41 can implement 1-level replacement, and a power distribution device on the power cabinet 2, a power distribution device on the bypass cabinet 3, and a power distribution device on the control cabinet 4 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

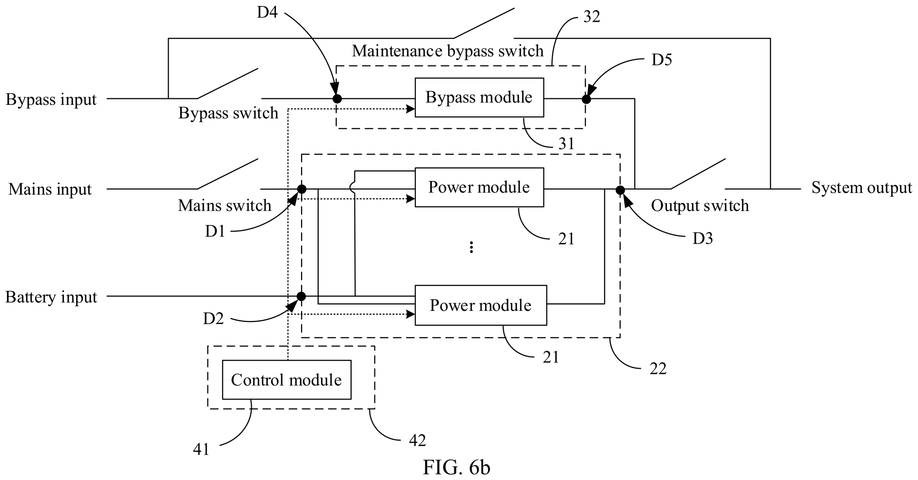

FIG. 6b is a schematic of a circuit principle of the uninterruptible power supply cabinet 10 shown in FIG. 6a. Breakpoints D formed between the first power connection end g1 of the cabinet body 1 and the second power connection end g2 of the power cabinet 2 are distributed at a plurality of positions, and specifically include a breakpoint D1 between a mains switch and a power module component formed by connecting the plurality of power modules 21 in parallel, a breakpoint D2 between a battery input and the power module component formed by connecting the plurality of power modules 21 in parallel, and a breakpoint D3 between an output switch and the power module component formed by connecting the plurality of power modules 21 in parallel. When the power cabinet 2 is mounted in the cabinet 1, all the breakpoints D may be connected, so that each power module 21 can be connected to a power supply network. Breakpoints D formed between the first bypass power connection end p1 of the cabinet body 1 and the second bypass connection end p1 of the bypass cabinet 3 are distributed at two positions, and specifically include a breakpoint D4 between a bypass switch and the bypass module 31 and a breakpoint D5 between the bypass module 31 and the output switch. When the bypass cabinet 3 is mounted in the cabinet 1, all the breakpoints D may be connected, so that the bypass module 31 can be connected to the power supply network. When the power cabinet 2 and the bypass cabinet 3 are removed out of the cabinet 1, all the breakpoints D may be disconnected.

During specific implementation, the uninterruptible power supply cabinet 10 may integrate different modules into one cabinet, to facilitate mounting and removal, thereby saving space, and optimizing an arrangement manner of components. In the following embodiments, different layout manners of the uninterruptible power supply cabinet 10 are described.

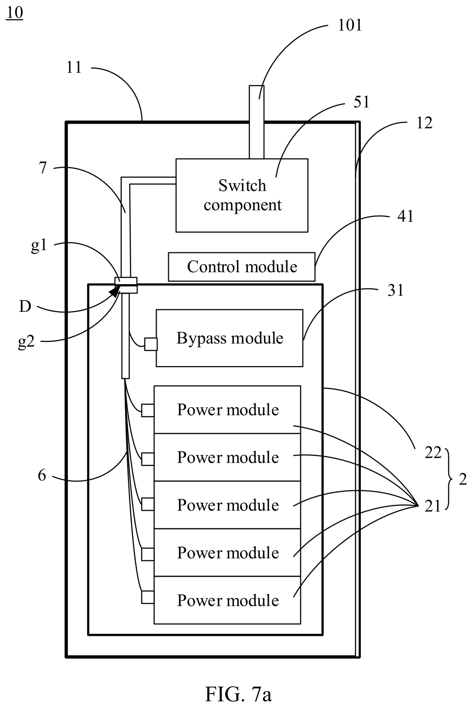

An uninterruptible power supply cabinet 10 shown in FIG. 7a includes a power cabinet 2, where the power cabinet 2 includes a first frame 22 and a power module 21 detachably mounted on the first frame 22. A first power connection end g1 of a cabinet body 1 is detachably connected to a second power connection end g2 on the first frame 22 to form an electrical connection breakpoint D. Each power module 21 is detachably mounted on the first frame 22, so that the power module 21 is detachable relative to the first frame 22 to facilitate replacement and maintenance. A bypass module 31 is also detachably mounted on the first frame 22, so that the bypass module 31 is detachable relative to the first frame 22 to facilitate replacement and maintenance. Both the bypass module 31 and each power module 21 are detachably and electrically connected to the second power connection end g2 of the first frame 22.

When the first frame 22 of the power cabinet 2 is mounted in the cabinet body 1, the second power connection end g2 and the first power connection end g1 can be in contact to implement an electrical connection. When the first frame 22 of the power cabinet 2 is removed out of the cabinet body 1, the second power connection end g2 may be disconnected from the first power connection end g1. When both the bypass module 31 and the plurality of power modules 21 are mounted on the first frame 22 and are located at a mounting position, both the bypass module 31 and the plurality of power modules 21 are electrically connected to the second power connection end g2. When the bypass module 31 is detached from the first frame 22, the bypass module 31 is separated from the second power connection end g2. When the power module 21 is detached from the first frame 22, the power module 21 is separated from the second power connection end g2.

It can be seen from FIG. 7a that, the electrical connection breakpoint between the power cabinet 2 and the cabinet body 1 may be formed between the second power connection end g2 and the first power connection end g1, so that the first frame 22 of the power cabinet 2 can be detachably removed out of the cabinet body 1, and power distribution devices, such as the second power connection end g2 and a cable component 6, that are on the first frame 22 can be removed out of the cabinet body 1 together with the first frame 22. In this case, these power distribution devices may be maintained. In addition, the power module 21 and the bypass module 31 that are detachably mounted on the first frame 22 may also be detached and removed out of the first frame 22. For the entire uninterruptible power supply cabinet 10, the power module 21 and the bypass module 31 can implement 1-level replacement, and a power distribution device that is on the power cabinet 2 and that is used to connect the power module 21 and the switch component 51, and a power distribution device that is on the power cabinet and that is used to connect the bypass module 31 and the switch component 51 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

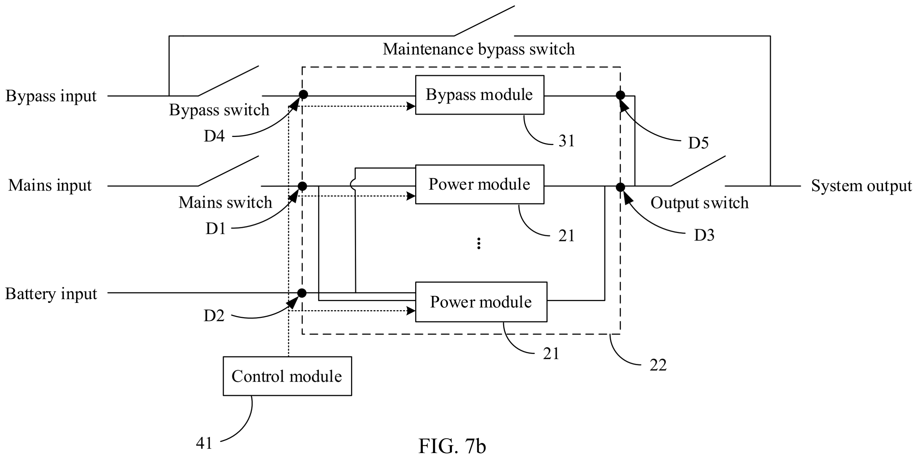

FIG. 7b is a schematic of a circuit principle of the uninterruptible power supply cabinet 10 shown in FIG. 7a. Breakpoints D formed between the second power connection end g2 of the cabinet body 1 and the first power connection end g1 of the power cabinet 2 are distributed at a plurality of positions, and specifically include a breakpoint D1 between a mains switch and a power module component formed by connecting the plurality of power modules 21 in parallel, a breakpoint D2 between a battery input and the power module component formed by connecting the plurality of power modules 21 in parallel, a breakpoint D3 between an output switch and the power module component formed by connecting the plurality of power modules 21 in parallel, a breakpoint D4 between the bypass module 31 and a bypass switch, and a breakpoint D5 between the bypass module 31 and the output switch. When the power cabinet 2 is mounted in the cabinet 1, all the breakpoints D may be connected, so that each power module 21 and the bypass module 31 can be connected to a power supply network. When the power cabinet 2 is removed out of the cabinet 1, all the breakpoints D may be disconnected.

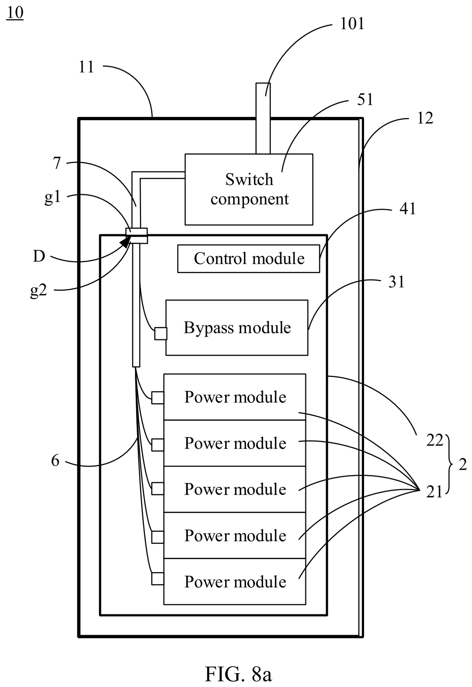

Based on the uninterruptible power supply cabinet 10 shown in FIG. 7a, FIG. 8a shows another uninterruptible power supply cabinet 10. As shown in FIG. 8a, a control module 41 is detachably mounted on a first frame 22 of a power cabinet 2, in other words, the control module 41, a bypass module 31, and a plurality of power modules 21 are integrated into the power cabinet 2.

In the uninterruptible power supply cabinet 10 shown in FIG. 8a, a first frame 22 of the power cabinet 2 can be detachably removed out of a cabinet body 1, and power distribution devices, including a second power connection end g2 and a cable component 6, that are on the first frame 22 can be removed out of the cabinet body 1 together with the first frame 22. In this case, these power distribution devices may be maintained. The power module 21, the bypass module 31, and the control module 41 that are detachably mounted on the first frame 22 may also be detached and removed out of the first frame 22. For the entire uninterruptible power supply cabinet 10, the power module 21, the bypass module 31, and the control module 41 can implement 1-level replacement, and the power distribution devices on the power cabinet 2 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

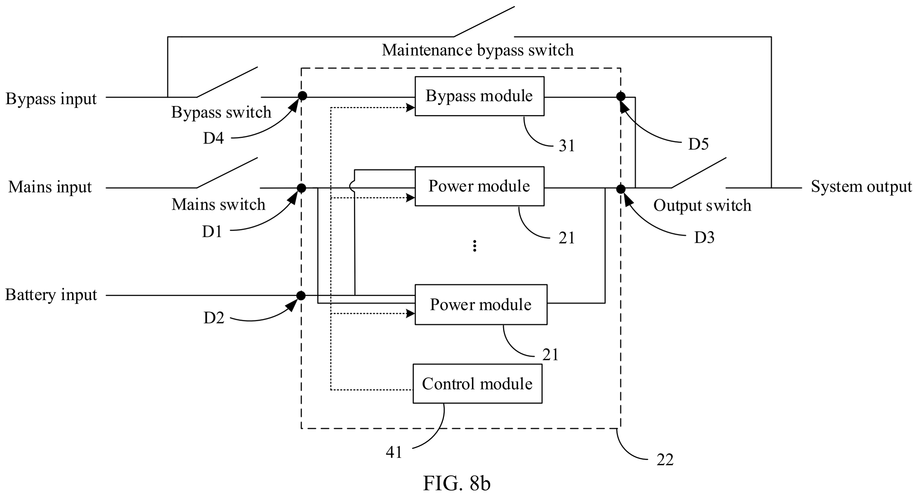

FIG. 8b is a schematic of a circuit principle of the uninterruptible power supply cabinet 10 shown in FIG. 8a. The control module 41 may be signal-connected to the bypass module 31 and each power module 21, and may be specifically connected in a wired manner or a wireless manner. Certainly, when the control module 41 is connected to the bypass module 31 and the power module 21 in the wired manner, a connection form is detachable.

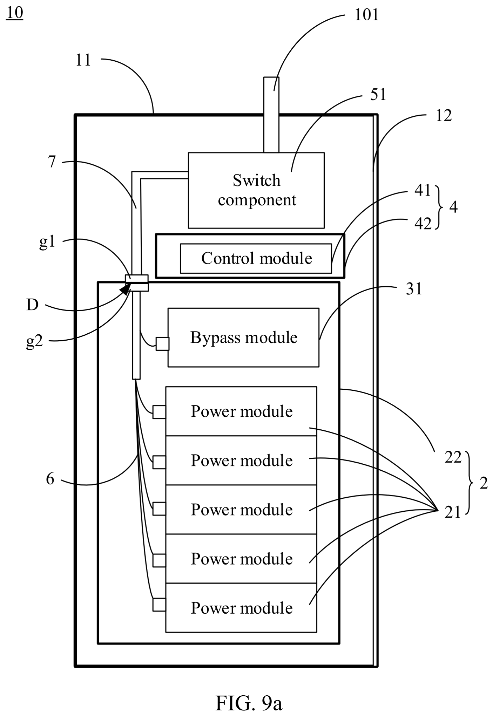

Based on the uninterruptible power supply cabinet 10 shown in FIG. 7a, FIG. 9a shows an uninterruptible power supply cabinet 10 including a control cabinet 4. As shown in FIG. 9a, the control cabinet 4 includes a third frame 42 and a control module 41 detachably mounted on the third frame 42.

In the uninterruptible power supply cabinet 10 shown in FIG. 9a, a first frame 22 of a power cabinet 2 can be detachably removed out of a cabinet body 1, and power distribution devices, such as a second power connection end g2 and a cable component 6, that are on the first frame 22 can be removed out of the cabinet body 1 together with the first frame 22. In this case, these power distribution devices may be maintained. A power module 21 and a bypass module 31 that are detachably mounted on the first frame 22 may also be detached and removed out of the first frame 22. In addition, the third frame 42 of the control module 4 can be detachably removed out of the cabinet body 1. In this case, a power distribution device on the third frame 42 may be maintained. The control module 41 that is detachably mounted on the third frame 42 may also be detached and removed out of the third frame 42. For the entire uninterruptible power supply cabinet 10, the power module 21, the bypass module 31, and the control module 41 can implement 1-level replacement, and a power distribution device on the power cabinet 2 and a power distribution device on a control cabinet 3 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

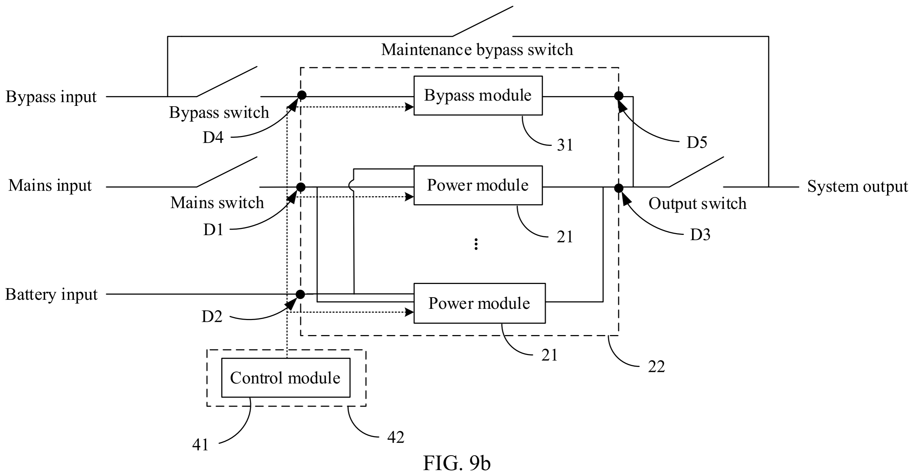

FIG. 9b is a schematic of a circuit principle of the uninterruptible power supply cabinet 10 shown in FIG. 9a. The control module 41 may be signal-connected to the bypass module 31 and each power module 21, and may be specifically connected in a wired manner or a wireless manner. Certainly, when the control module 41 is connected to the bypass module 31 and the power module 21 in the wired manner, a connection form is detachable.

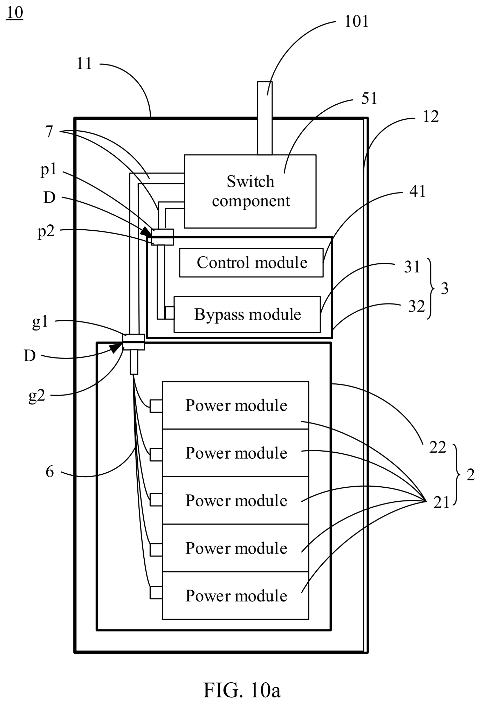

An uninterruptible power supply cabinet 10 shown in FIG. 10a includes a power cabinet 2 and a bypass cabinet 3, where the power cabinet 2 includes a first frame 22 and a power module 21 detachably mounted on the first frame 22. A first power connection end g1 of a cabinet body 1 is detachably connected to a second power connection end g2 on the first frame 22 to form an electrical connection breakpoint D. Each power module 21 is detachably mounted on the first frame 22, so that the power module 21 is detachable relative to the first frame 22 to facilitate replacement and maintenance. The bypass cabinet 3 includes a second frame 32 and a power module 31 detachably mounted on the second frame 32. A first bypass connection end p1 of the cabinet body 1 is detachably connected to a second bypass connection end p2 on the second frame 32 to form an electrical connection breakpoint D. A control module 41 is also detachably mounted on the second frame 32, so that the control module 41 is detachable relative to the second frame 32 to facilitate replacement and maintenance.

When the first frame 22 of the power cabinet 2 is mounted in the cabinet body 1, the second power connection end g2 and the first power connection end g1 can be in contact to implement an electrical connection. When the first frame 22 of the power cabinet 2 is removed out of the cabinet body 1, the second power connection end g2 may be disconnected from the first power connection end g1. When a plurality of power modules 21 are mounted on the first frame 22 and are located at a mounting position, the plurality of power modules 21 are electrically connected to the second power connection end g2. When the power module 21 is detached from the first frame 22, the power module 21 is separated from the second power connection end g2. When the second frame 32 of the bypass cabinet 3 is mounted in the cabinet body 1, the second bypass connection end p2 and the first bypass connection end p1 can be in contact to implement an electrical connection. When the second frame 32 of the bypass cabinet 3 is removed out of the cabinet body 1, the second bypass connection end p2 may be disconnected from the first bypass connection end p1, and the control module 41 may also be removed together with the second frame 32. When the bypass module 31 is mounted on the second frame 32 and is located at a mounting position, the bypass module 31 is electrically connected to the second bypass connection end p1, and the control module 41 is signal-connected to the bypass module 31 and the plurality of power modules 21.

It can be seen from FIG. 10a that, the electrical connection breakpoint between the power cabinet 2 and the cabinet body 1 may be formed between the second power connection end g2 and the first power connection end g1, so that the first frame 22 of the power cabinet 2 can be detachably removed out of the cabinet body 1, and power distribution devices, such as the second power connection end g2 and a cable component 6, that are on the first frame 22 can be removed out of the cabinet body 1 together with the first frame 22. In this case, these power distribution devices may be maintained. In addition, the power module 21 that is detachably mounted on the first frame 22 may also be detached and removed out of the first frame 22. The electrical connection breakpoint between the bypass cabinet 3 and the cabinet body 1 may be formed between the second bypass connection end p2 and the first power connection end p1, so that the second frame 32 of the bypass cabinet 3 can be detachably removed out of the cabinet body 1, and power distribution devices, such as the second bypass connection end p2, on the second frame 32 can be removed out of the cabinet body 1 together with the second frame 32. In this case, these power distribution devices may be maintained. In addition, the control module 41 that is detachably mounted on the second frame 32 may also be detached and removed out of the second frame 32.

For the entire uninterruptible power supply cabinet 10, the power module 21, the bypass module 31, and the control module 41 can implement 1-level replacement, and a power distribution device on the power cabinet 2 and a power distribution device on the bypass cabinet 3 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

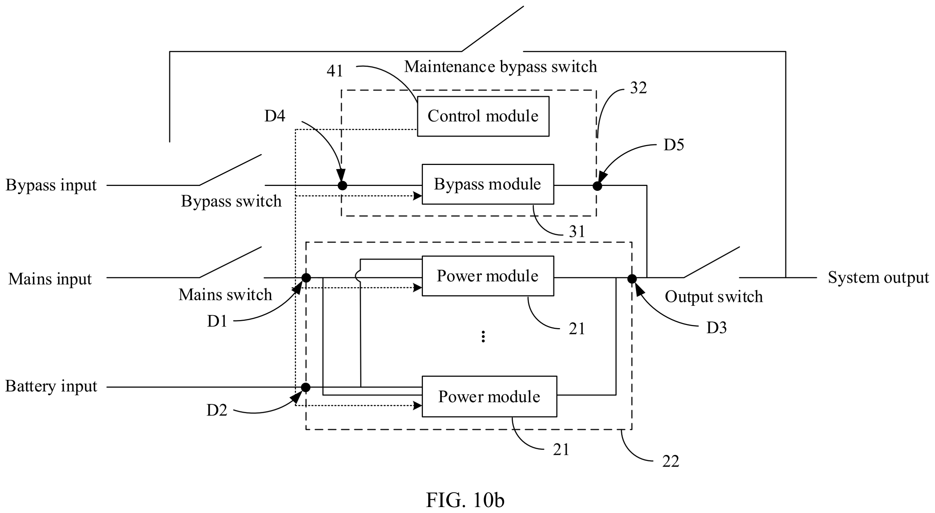

FIG. 10b is a schematic of a circuit principle of the uninterruptible power supply cabinet 10 shown in FIG. 10a. Breakpoints D formed between the second power connection end g2 of the cabinet body 1 and the first power connection end g1 of the power cabinet 2 are distributed at a plurality of positions, and specifically include a breakpoint D1 between a mains switch and a power module component formed by connecting the plurality of power modules 21 in parallel, a breakpoint D2 between a battery input and the power module component formed by connecting the plurality of power modules 21 in parallel, a breakpoint D3 between an output switch and the power module component formed by connecting the plurality of power modules 21 in parallel, a breakpoint D4 between the bypass module 31 and a bypass switch, and a breakpoint D5 between the bypass module 31 and the output switch. When the power cabinet 2 is mounted in the cabinet 1, all the breakpoints D may be connected, so that each power module 21 and the bypass module 31 can be connected to a power supply network. When the power cabinet 2 and the bypass cabinet 3 are removed out of the cabinet 1, all the breakpoints D may be disconnected.

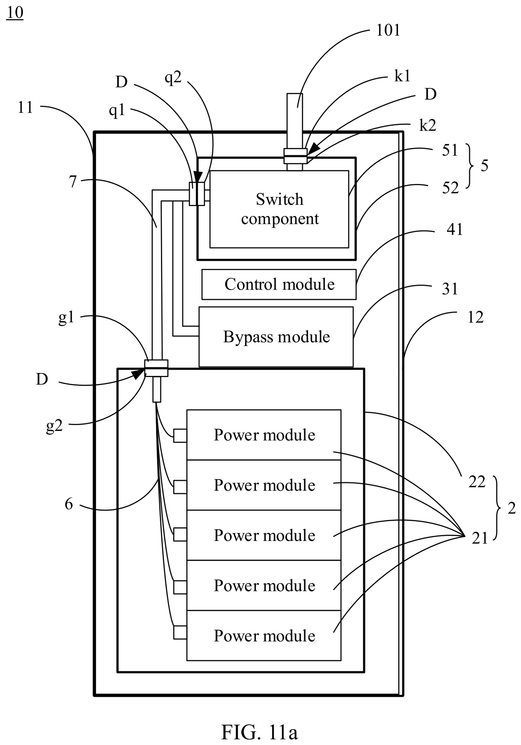

In some other embodiments, based on the structure shown in FIG. 3b, an uninterruptible power supply cabinet 10 shown in FIG. 11a includes a switch cabinet 5, where the switch cabinet 5 includes a fourth frame 52 and a switch component 51 detachably mounted on the fourth frame 52. The cabinet body 1 includes a first power connection end g1, a first flat cable connection end q1, and a first switch connection end k1 connected to an external port 101. The first power connection end g1 may be connected to the first flat cable connection end q1 through a copper bar component 7. The fourth frame 52 includes a second switch connection end k2, and the second switch connection end k2 is configured to detachably and electrically connect to the first switch connection end k1. An electrical connection breakpoint D between the switch cabinet 5 and the cabinet body 1 is formed between the second switch connection end k2 and the first switch connection end k1. The fourth frame 52 of the switch cabinet 5 further includes a second flat cable connection end q2, where the second flat cable connection end q2 is configured to detachably and electrically connect to the first flat cable connection end q1, and another electrical connection breakpoint D between the switch cabinet 5 and the cabinet body 1 is formed between the second flat cable connection end and the first flat cable connection end. The first power connection end g1 is detachably and electrically connected to the second power connection end g2 of the power cabinet 2, and an electrical connection breakpoint D between the power cabinet 2 and the cabinet body 1 is formed between the first power connection end and the second power connection end. When the fourth frame 52 of the switch cabinet 5 is mounted in the cabinet body 1, the second switch connection end k2 and the first switch connection end k1 can be in contact to implement an electrical connection, and the second flat cable connection end q2 and the first flat cable connection end q1 can be in contact to implement an electrical connection. When the first frame 22 of the power cabinet 2 is removed out of the cabinet body 1, the second power connection end g2 may be disconnected from the first power connection end g1, and the second flat cable connection end q2 may be disconnected from the first flat cable connection end q1. For example, a bypass module 31 is connected to the first flat cable connection end q1 through a power distribution device such as a copper bar.

It can be seen from FIG. 11a that, the electrical connection breakpoint D between the power cabinet 2 and the cabinet body 1 may be formed between the second power connection end g2 and the first power connection end g1, so that the first frame 22 of the power cabinet 2 can be detachably removed out of the cabinet body 1, and power distribution devices, such as the second power connection end g2 and a cable component 6, that are on the first frame 22 can be removed out of the cabinet body 1 together with the first frame 22. In this case, these power distribution devices may be maintained. The two electrical connection breakpoints D between the switch cabinet 5 and the cabinet body 1 are respectively formed between the second flat cable connection end q2 and the first flat cable connection end q1, and between the second switch connection end k2 and the first switch connection end k1, so that the fourth frame 52 of the switch cabinet 5 can be detachably removed out of the cabinet body 1, and power distribution devices, including the second switch connection end k2 and the second flat cable connection end q2, that are on the fourth frame 52 can be removed out of the cabinet body 1 together with the fourth frame 52. In this case, these power distribution devices may be maintained. In addition, the power module 21 that is detachably mounted on the first frame 22 may be detached and removed out of the first frame 22, and the switch component 51 that is detachably mounted on the fourth frame 52 may also be removed out of the fourth frame 52. For the entire uninterruptible power supply cabinet 10, the power module 21 and the switch component 51 can implement 1-level replacement, and a power distribution device on the power cabinet 2 and a power distribution device on the switch cabinet 5 can implement 2-level replacement. Compared with the conventional technology, in this application, power distribution devices, such as a copper bar and a cable, that cannot be usually replaced in the past may be detached and removed for maintenance. This improves maintenance convenience, and can improve system reliability.

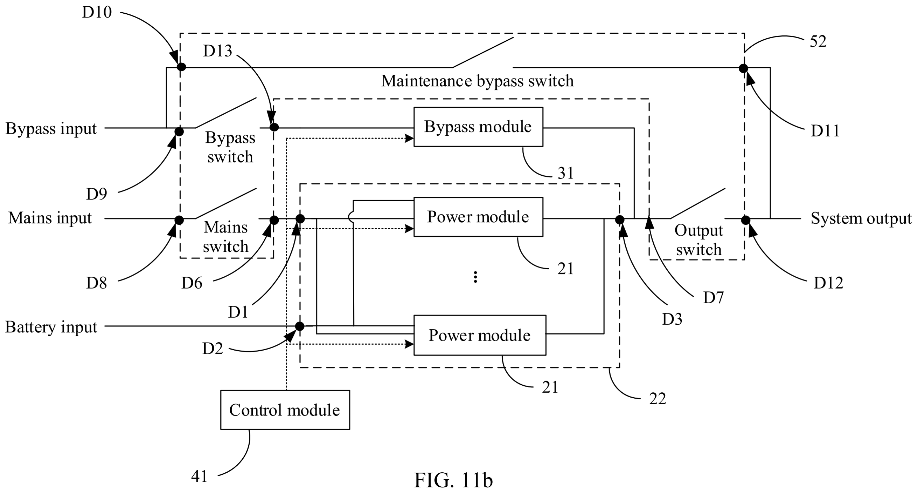

FIG. 11b is a schematic of a circuit principle of the uninterruptible power supply cabinet 10 shown in FIG. 11a. Breakpoints D formed between the second power connection end g2 of the power cabinet 2 and the first power connection end g1 of the cabinet body 1 are distributed at a plurality of positions, and specifically include a breakpoint D1 between a mains switch and a power module component formed by connecting a plurality of power modules 21 in parallel, a breakpoint D2 between a battery input and the power module component formed by connecting the plurality of power modules 21 in parallel, a breakpoint D3 between an output switch and the power module component formed by connecting the plurality of power modules 21 in parallel, a breakpoint D4 between the bypass module 31 and a bypass switch, and a breakpoint D5 between the bypass module 31 and the output switch. Breakpoints D formed between the second flat cable connection end q2 of the switch cabinet 5 and the first flat cable connection end q1 of the cabinet body 1 are distributed at a plurality of positions, and specifically include another breakpoint D6 between the mains switch and the power module component formed by connecting the plurality of power modules 21 in parallel, another breakpoint D7 between the output switch and the power module component formed by connecting the plurality of power modules 21 in parallel, and another breakpoint D13 between the bypass switch and the bypass module 31. Both the breakpoint D13 and the breakpoint D4 are located between the bypass switch and the bypass module 31, the breakpoint D13 is formed by the second flat cable connection end q2 and the first flat cable connection end q1, and the breakpoint D4 is formed by the second power connection end g2 and the first power connection end g1 of the cabinet body 1. Breakpoints D formed between the second switch connection end k2 of the switch cabinet 5 and the first switch connection end k1 of the cabinet body 1 are distributed at a plurality of positions, and specifically include a breakpoint D8 between the mains switch and a mains input, a breakpoint D9 between the bypass switch and a bypass input, a breakpoint D10 between a maintenance bypass switch and the bypass input, a breakpoint D11 between the maintenance bypass switch and an output end, and a breakpoint D12 between the output switch and the output end. When the power cabinet 2 and the switch cabinet 5 are removed out of the cabinet 1, all the breakpoints D may be disconnected.

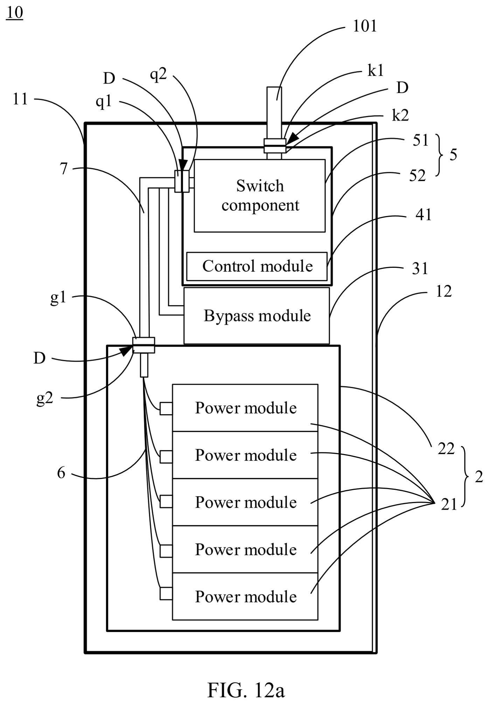

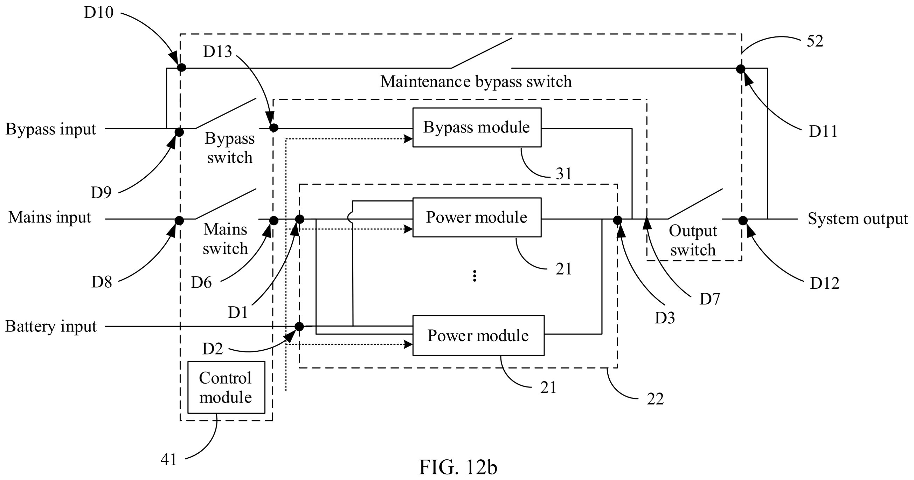

Based on the structure shown in FIG. 11a, FIG. 12a shows an uninterruptible power supply cabinet 10, where a control module 41 is detachably mounted on a fourth frame 52 of a switch cabinet 5. FIG. 12b is a schematic of a circuit principle of the uninterruptible power supply cabinet 10 shown in FIG. 12a. In addition to structures of the control module 41 and the fourth frame 52, other electrical connections are similar to those in FIG. 12b, and details are not described herein again. It should be understood that, the control module 41 and a switch component 51 share one cabinet, and it may be considered that the control module 41 is integrated into the switch cabinet 5, or it may be considered that the switch component 51 is integrated into the control cabinet 4. In other words, the fourth frame 52 in FIG. 12a and FIG. 12b may also be considered as a third frame 42.

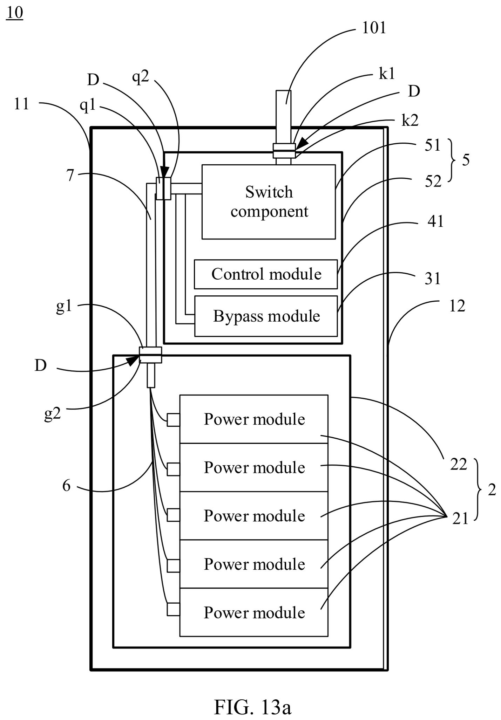

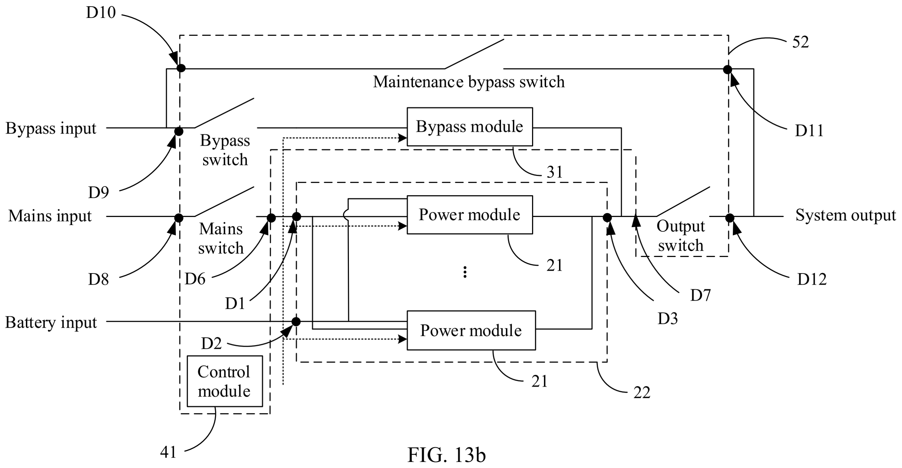

Based on the structure shown in FIG. 12a, FIG. 13a shows an uninterruptible power supply cabinet 10, where a bypass module 31 is detachably mounted on a fourth frame 52 of a switch cabinet 5. The bypass module 31 may be electrically connected to a switch component 51 through a power distribution device on the fourth frame 52. FIG. 13b is a schematic of a circuit principle of the uninterruptible power supply cabinet 10 shown in FIG. 13a. In addition to structures of the bypass module 31 and the fourth frame 52, other electrical connections are similar to those in FIG. 12a, and details are not described herein again. It should be understood that the bypass module 31, a control module 41, and the switch component 51 share one cabinet, and it may be considered that the bypass module 31 and the control module 41 are integrated into the switch cabinet 5, it may be considered that the switch component 51 and the bypass module 31 are integrated into a control cabinet 4, or it may be considered that the switch component 51 and the control module 41 are integrated into a bypass cabinet 3. In other words, the fourth frame 52 in FIG. 13a and FIG. 13b may also be considered as a third frame 42 or a second frame 32.

Based on an idea that a switch component 51 is replaceable, and with reference to different integration manners of a power module 21, a bypass module 31, and a control module 41, embodiments of this application further provide the following implementations of the uninterruptible power supply cabinet 10.

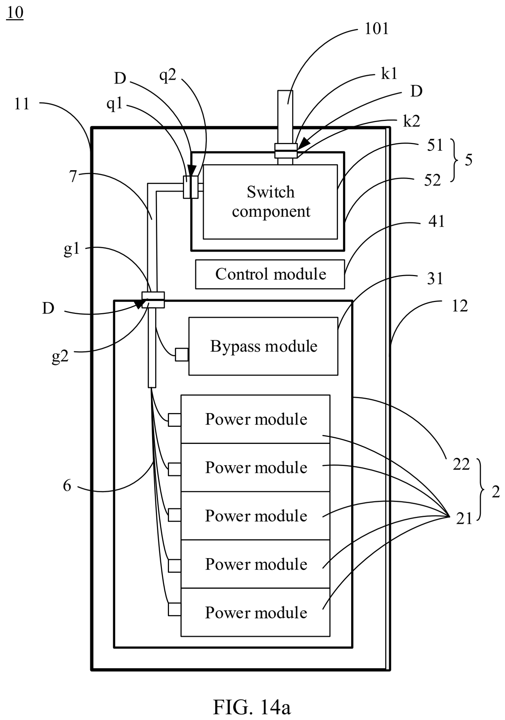

FIG. 14a shows an uninterruptible power supply cabinet 10. A bypass module 31 is detachably mounted on a first frame 22 of a power cabinet 2, and the bypass module 31 is detachably and electrically connected to a second power connection end g2 of the power cabinet 2. When the power cabinet 2 is mounted in a cabinet body 1, the bypass module 31 may be detachably and electrically connected to a first power connection end g1 of the cabinet body 1 through the second power connection end g2 of the power cabinet 2.

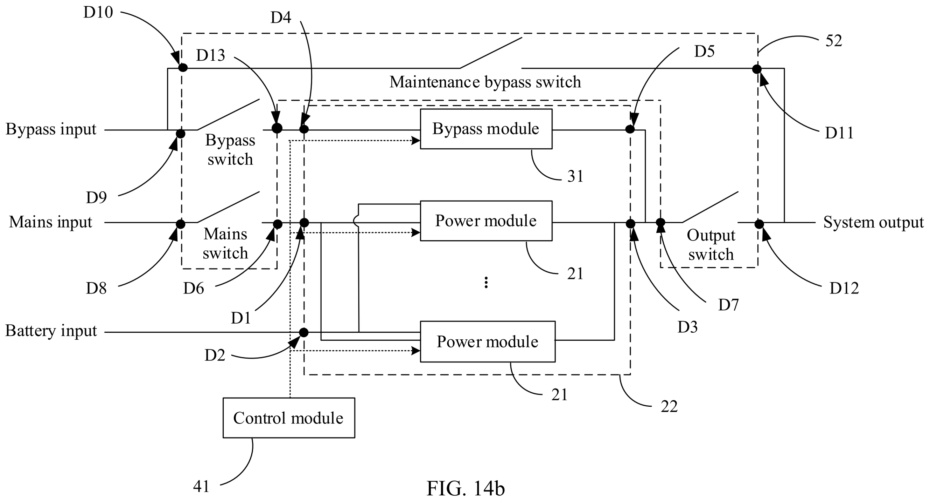

FIG. 14b is a schematic of a circuit principle of the uninterruptible power supply cabinet 10 shown in FIG. 14a. Breakpoints D formed between the second power connection end g2 of the power cabinet 2 and the first power connection end g1 of the cabinet body 1 are distributed at a plurality of positions, and specifically include a breakpoint D1 between a mains switch and a power module component formed by connecting a plurality of power modules 21 in parallel, a breakpoint D2 between a battery input and the power module component formed by connecting the plurality of power modules 21 in parallel, and a breakpoint D3 between an output switch and the power module component formed by connecting the plurality of power modules 21 in parallel. Breakpoints D formed between a second flat cable connection end q2 of a switch cabinet 5 and a first flat cable connection end q1 of the cabinet body 1 are distributed at a plurality of positions, and specifically include another breakpoint D6 between the mains switch and the power module component formed by connecting the plurality of power modules 21 in parallel, and another breakpoint D7 between the output switch and the power module component formed by connecting the plurality of power modules 21 in parallel. Both the breakpoint D6 and the breakpoint D1 are located between the mains switch and the power module component formed by connecting the plurality of power modules 21 in parallel, the breakpoint D6 is formed by the second flat cable connection end q2 and the first flat cable connection end q1, and the breakpoint D1 is formed by the second power connection end g2 and the first power connection end g1 of the cabinet body 1. Both the breakpoint D7 and the breakpoint D3 are located between the output switch and the power module component formed by connecting the plurality of power modules 21 in parallel, the breakpoint D7 is formed by the second flat cable connection end q2 and the first flat cable connection end q1, and the breakpoint D3 is formed by the second power connection end g2 and the first power connection end g1 of the cabinet body 1. Breakpoints D formed between a second switch connection end k2 of the switch cabinet 5 and a first switch connection end k1 of the cabinet body 1 are distributed at a plurality of positions, and specifically include a breakpoint D8 between the mains switch and a mains input, a breakpoint D9 between a bypass switch and a bypass input, a breakpoint D10 between a maintenance bypass switch and the bypass input, a breakpoint D11 between the maintenance bypass switch and an output end, and a breakpoint D12 between the output switch and the output end. When the power cabinet 2 and the switch cabinet 5 are mounted in the cabinet 1, all the breakpoints D may be connected, so that each power module 21 and the switch component 51 can be connected to a power supply network. When the power cabinet 2 and the switch cabinet 5 are removed out of the cabinet 1, all the breakpoints D may be disconnected.

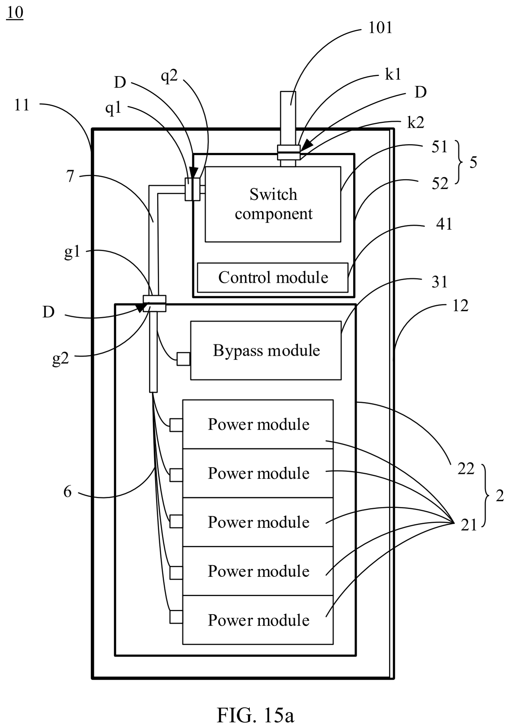

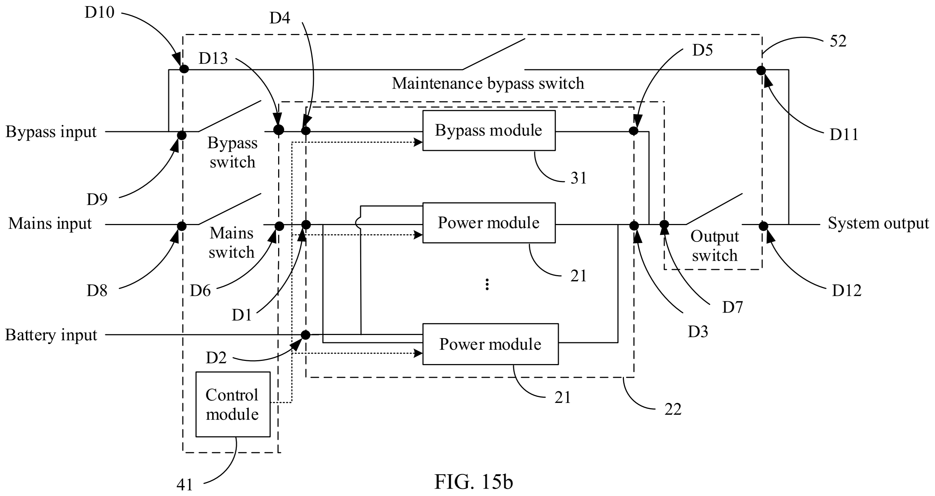

Based on the structure shown in FIG. 14a, FIG. 15a shows an uninterruptible power supply cabinet 10, where a control module 41 is detachably mounted on a fourth frame 52 of a switch cabinet 5. FIG. 15b is a schematic of a circuit principle of the uninterruptible power supply cabinet 10 shown in FIG. 15a. In addition to structures of the control module 41 and the fourth frame 52, other electrical connections are similar to those in FIG. 12b, and details are not described herein again.

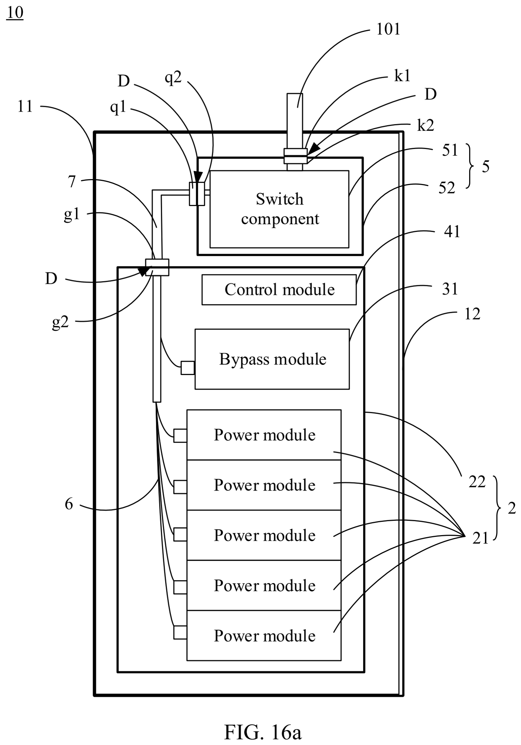

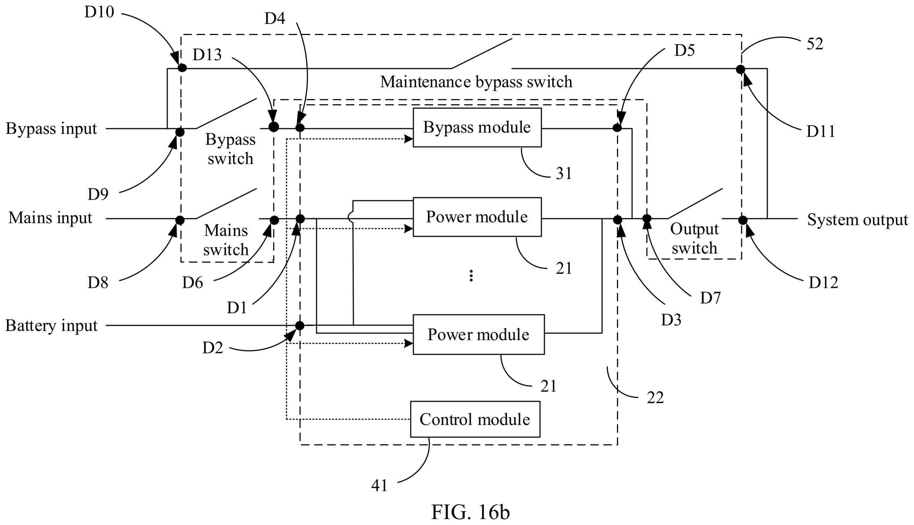

Based on the structure shown in FIG. 14a, FIG. 16a shows an uninterruptible power supply cabinet 10, where a control module 41 is detachably mounted on a first frame 22 of a power cabinet 2. FIG. 16b is a schematic of a circuit principle of the uninterruptible power supply cabinet 10 shown in FIG. 16a. In addition to structures of the control module 41 and the first frame 22, other electrical connections are similar to those in FIG. 14b, and details are not described herein again.

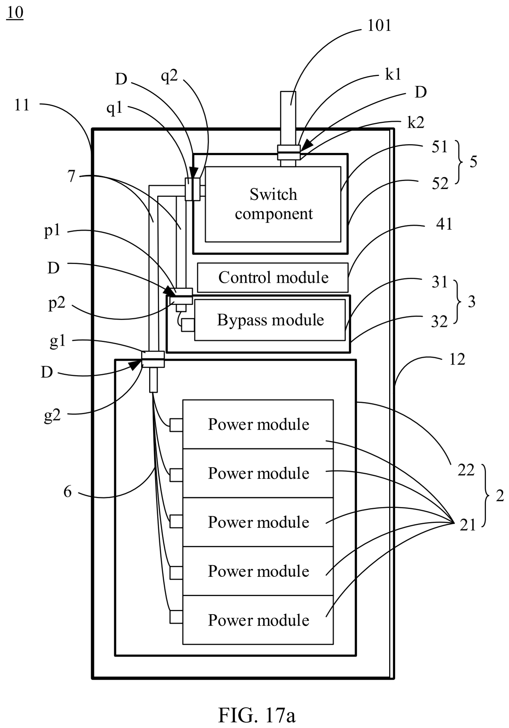

FIG. 17a shows an uninterruptible power supply cabinet 10, where the uninterruptible power supply cabinet 10 includes a bypass cabinet 3 disposed in a cabinet body 1. The bypass cabinet 3 includes a second frame 32 and a bypass module 31 detachably mounted on the second frame 32. The cabinet body 1 includes a first bypass connection end p1, the second frame 32 includes a second bypass connection end p2, and the bypass module 31 is detachably and electrically connected to the second bypass connection end p2. The second bypass connection end p2 on the second frame 32 is configured to connect to the first bypass connection end p1.

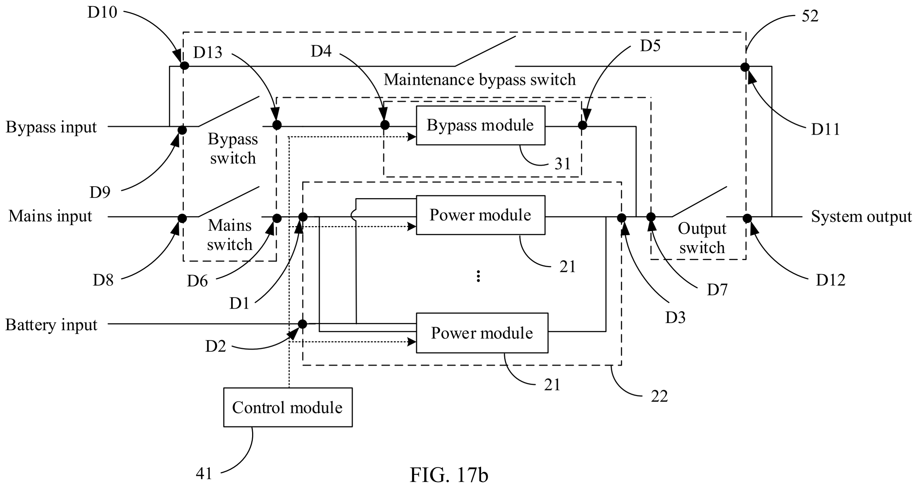

FIG. 17b is a schematic of a circuit principle of the uninterruptible power supply cabinet 10 shown in FIG. 17a. Breakpoints D formed between the first bypass power connection end p1 of the cabinet body 1 and the second bypass connection end p1 of the bypass cabinet 3 are distributed at two positions, and specifically include a breakpoint D4 between a bypass switch and the bypass module 31 and a breakpoint D5 between the bypass module 31 and an output switch. Breakpoints D formed between a second flat cable connection end q2 of a switch cabinet 5 and a first flat cable connection end q1 of the cabinet body 1 are distributed at a plurality of positions, and specifically include another breakpoint D6 between a mains switch and a power module component formed by connecting a plurality of power modules 21 in parallel, another breakpoint D7 between the output switch and the power module component formed by connecting the plurality of power modules 21 in parallel, and another breakpoint D13 between a bypass switch and the bypass module 31. Both the breakpoint D13 and the breakpoint D4 are located between the bypass switch and the bypass module 31, the breakpoint D13 is formed by the second flat cable connection end q2 and the first flat cable connection end q1, and the breakpoint D4 is formed by the second bypass connection end p2 and the first bypass connection end p1 of the cabinet body 1. A breakpoint D formed between a second switch connection end k2 of the switch cabinet 5 and a first switch connection end k1 of the cabinet body 1 is similar to that in FIG. 11b, and a breakpoint D formed between a second power connection end g2 of the power cabinet 2 and a first power connection end g1 of the cabinet body 1 is similar to that in FIG. 11b. Details are not described herein again. When the power cabinet 2, the bypass cabinet 3, and the switch cabinet 5 are removed out of the cabinet 1, all the breakpoints D may be disconnected.

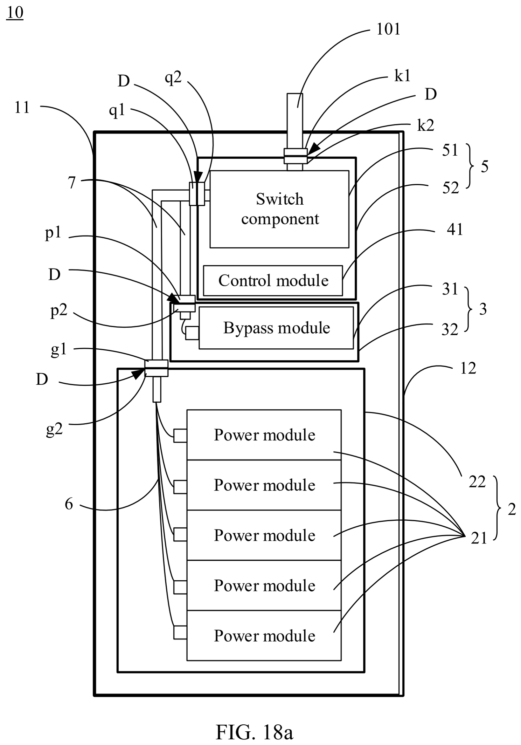

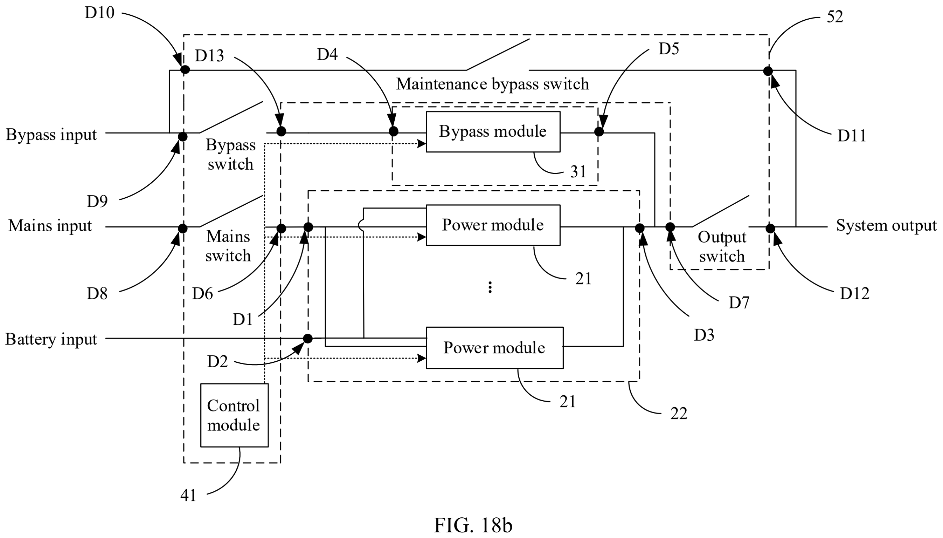

Based on the structure shown in FIG. 17a, FIG. 18a shows an uninterruptible power supply cabinet 10, where a control module 41 is detachably mounted on a fourth frame 52 of a switch cabinet 5. FIG. 18b is a schematic of a circuit principle of the uninterruptible power supply cabinet 10 shown in FIG. 18a. In addition to structures of the control module 41 and the fourth frame 52, other electrical connections are similar to those in FIG. 17b, and details are not described herein again.

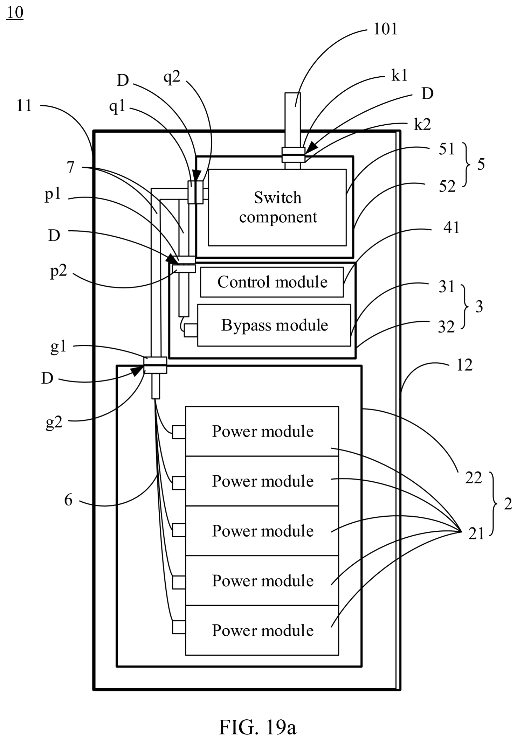

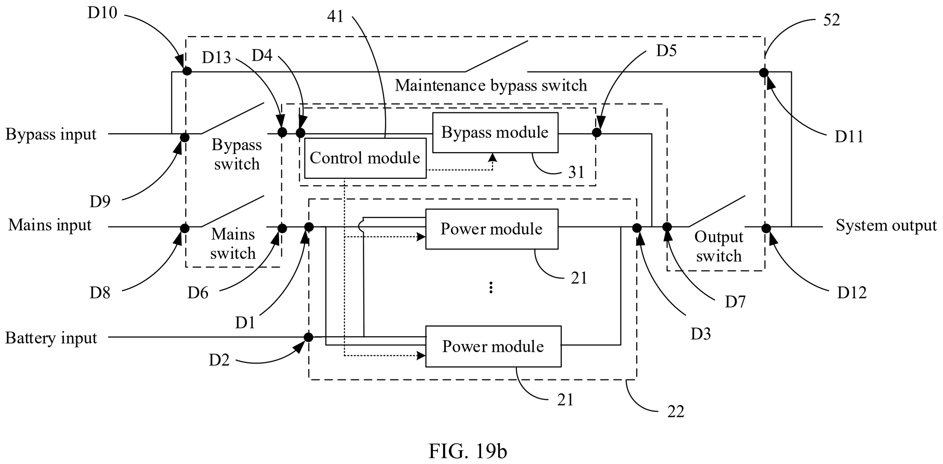

Based on the structure shown in FIG. 17a, FIG. 19a shows an uninterruptible power supply cabinet 10, where a control module 41 is detachably mounted on a second frame 32 of a bypass cabinet 3. It should be understood that, the control module 41 and a bypass module 31 share one cabinet, and it may be considered that the control module 41 is integrated into a bypass cabinet 3, or it may be considered that the bypass module 31 is integrated into a control cabinet 4. In other words, the second frame 32 in FIG. 19a and FIG. 19b may also be considered as a third frame 42.

FIG. 19b is a schematic of a circuit principle of the uninterruptible power supply cabinet 10 shown in FIG. 19a. In addition to structures of the control module 41 and the second frame 32, other electrical connections are similar to those in FIG. 17b, and details are not described herein again.

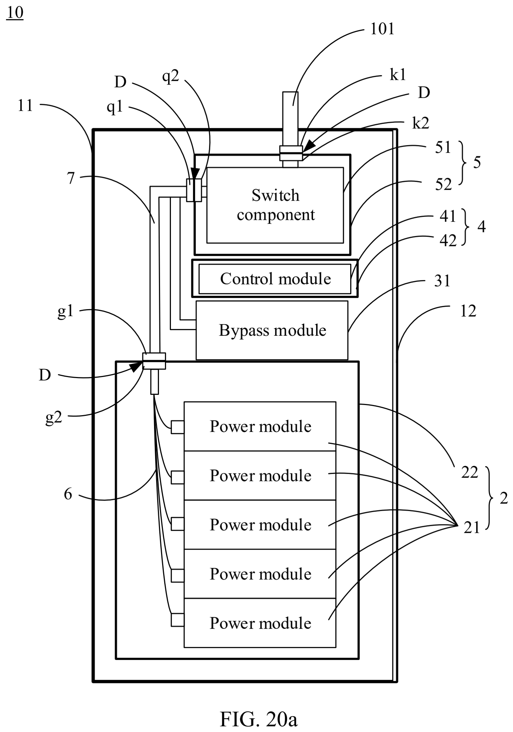

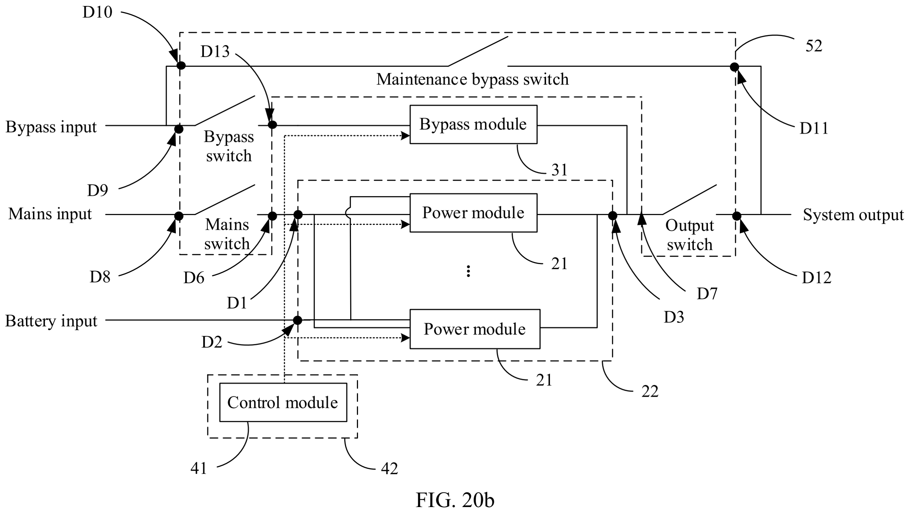

FIG. 20a shows an uninterruptible power supply cabinet 10, and a structure of the uninterruptible power supply cabinet 10 is similar to that shown in FIG. 11a. A difference lies in that, the uninterruptible power supply cabinet 10 includes a control cabinet 4, where the control cabinet 4 includes a third frame 42 and a control module 41 detachably mounted on the third frame 42. FIG. 20b is a schematic of a circuit principle of the uninterruptible power supply cabinet 10 shown in FIG. 20a. In addition to structures of the control module 41 and the third frame 42, other electrical connections are similar to those in FIG. 11b, and details are not described herein again.

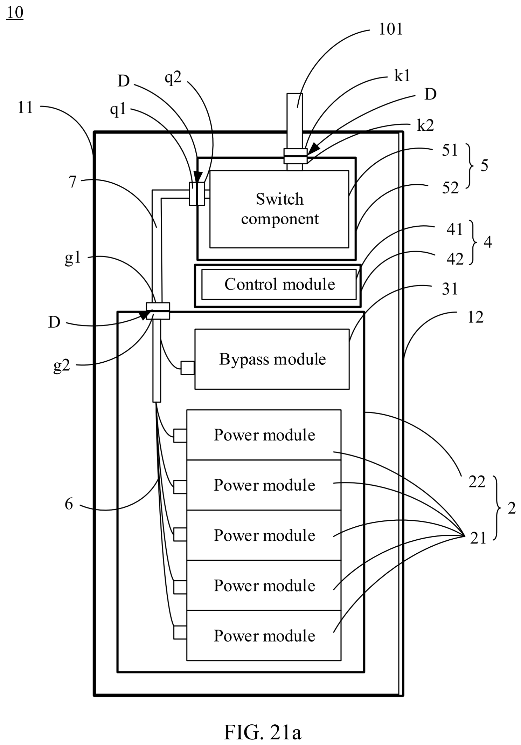

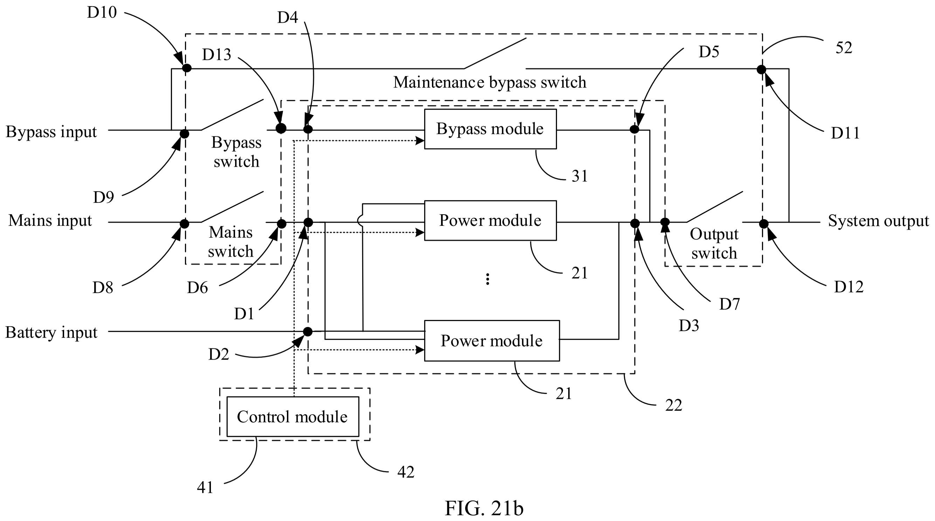

Based on the structure shown in FIG. 20a, FIG. 21a shows an uninterruptible power supply cabinet 10, and a structure of the uninterruptible power supply cabinet 10 is similar to that shown in FIG. 14a. A difference lies in that, the uninterruptible power supply cabinet 10 includes a control cabinet 4, where the control cabinet 4 includes a third frame 42 and a control module 41 detachably mounted on the third frame 42. FIG. 21b is a schematic of a circuit principle of the uninterruptible power supply cabinet 10 shown in FIG. 21a. In addition to structures of the control module 41 and the third frame 42, other electrical connections are similar to those in FIG. 14b, and details are not described herein again.

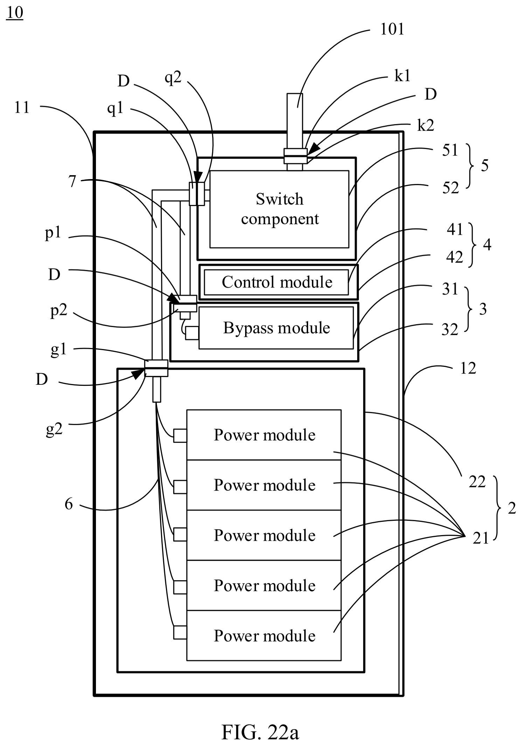

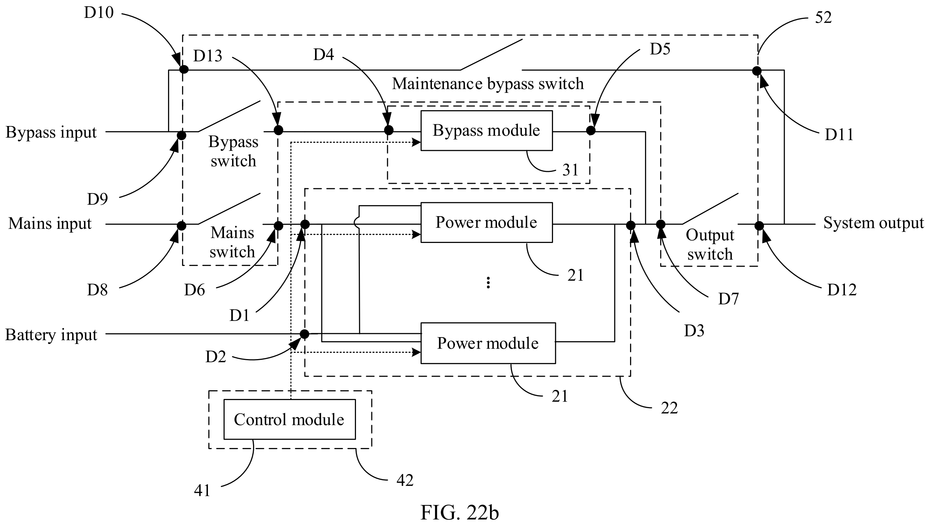

Based on the structure shown in FIG. 20a, FIG. 22a shows an uninterruptible power supply cabinet 10, and a structure of the uninterruptible power supply cabinet 10 is similar to that shown in FIG. 17a. A difference lies in that, the uninterruptible power supply cabinet 10 includes a control cabinet 4, where the control cabinet 4 includes a third frame 42 and a control module 41 detachably mounted on the third frame 42. FIG. 22b is a schematic of a circuit principle of the uninterruptible power supply cabinet 10 shown in FIG. 22a. In addition to structures of the control module 41 and the third frame 42, other electrical connections are similar to those in FIG. 17b, and details are not described herein again.

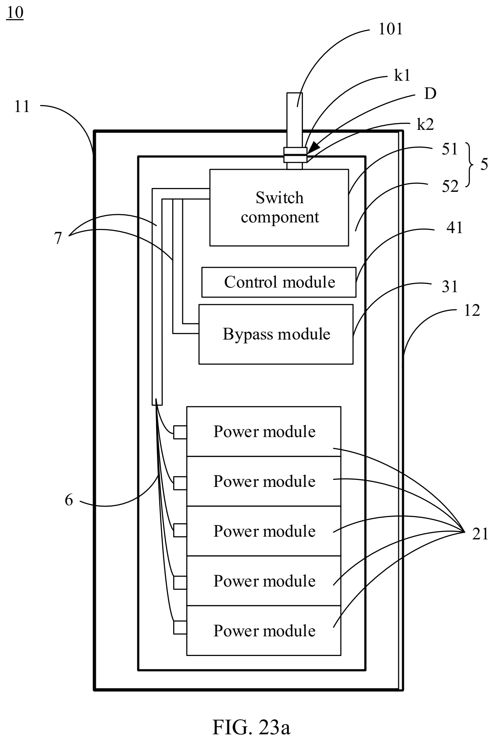

FIG. 23a shows another uninterruptible power supply cabinet 10. The uninterruptible power supply cabinet 10 includes a switch cabinet 5, and the switch cabinet 5 includes a fourth frame 52 and a switch component 51 detachably mounted on the fourth frame 52. A cabinet body 1 includes a first switch connection end k1 connected to an external port 101, and the fourth frame 52 includes a second switch connection end k2. The second switch connection end k2 is configured to detachably and electrically connect to the first switch connection end k1, and the switch component 51 is detachably and electrically connected to the second switch connection end k2. An electrical connection breakpoint D between the switch cabinet 5 and the cabinet body 1 is formed between the second switch connection end k2 and the first switch connection end k1. A power module 21, a bypass module 31, and a control module 41 are all detachably mounted on the fourth frame 52, and both the power module 21 and the bypass module 31 are detachably and electrically connected to the second switch connection end k2. When the fourth frame 52 of the switch cabinet 5 is mounted in the cabinet body 1, the second switch connection end k2 and the first switch connection end k1 can be in contact to implement an electrical connection.

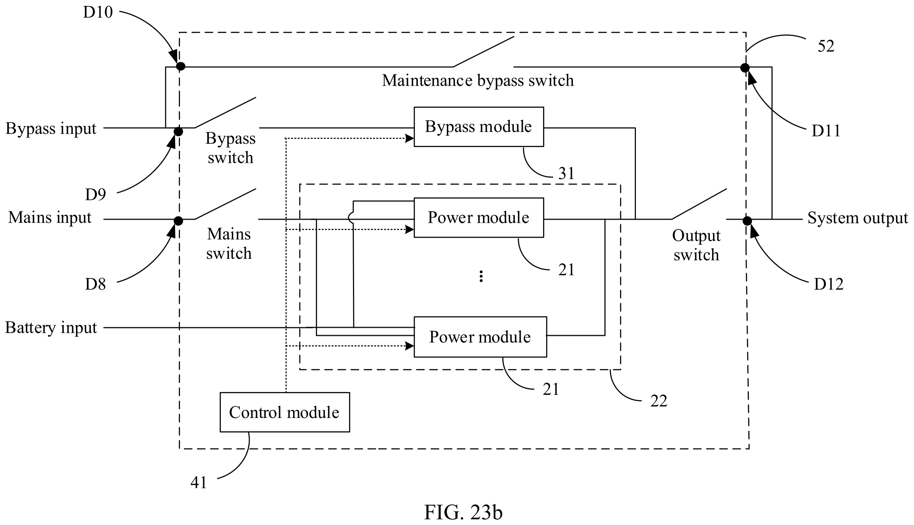

FIG. 23b is a schematic of a circuit principle of the uninterruptible power supply cabinet 10 shown in FIG. 23a. Breakpoints D formed between the second switch connection end k2 of the switch cabinet 5 and the first switch connection end k1 of the cabinet body 1 are distributed at a plurality of positions, and specifically include a breakpoint D8 between a mains switch and a mains input, a breakpoint D9 between a bypass switch and a bypass input, a breakpoint D10 between a maintenance bypass switch and the bypass input, a breakpoint D11 between the maintenance bypass switch and an output end, and a breakpoint D12 between an output switch and the output end.

It can be learned from the foregoing embodiments that, in the uninterruptible power supply cabinets 10 provided in embodiments of this application, modules such as the power module 21, the bypass module 31, the control module 41, and the switch component 51 can implement 1-level replacement through hot swapping. In addition, power distribution devices such as a copper bar and a cable can be integrated to implement 2-level replacement. A component, that cannot be replaced in the past, in the cabinet body 1 can be replaced. This improves maintenance convenience and system reliability.

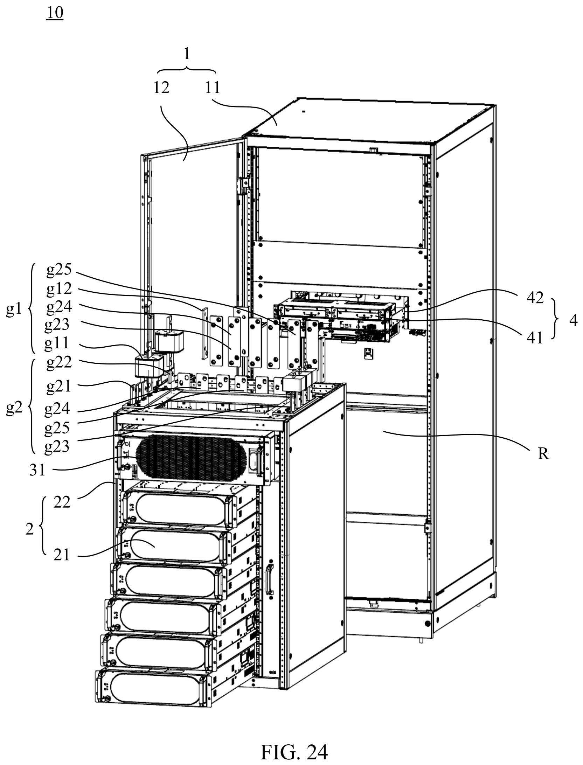

In the foregoing embodiments, for ease of understanding the solution, each uninterruptible power supply cabinet 10 is of a simplified structure. The structure shown in FIG. 9a and FIG. 9b is used as an example, to more intuitively understand the solution. FIG. 24 is a schematic diagram of assembly of an uninterruptible power supply cabinet 10. As shown in FIG. 24, an entire cabinet body 1 is in a cube shape, and is vertically placed in a normal use state, so that a height direction of the cabinet body 1 is a vertical direction. The cabinet body 1 includes a body 11 and a cabinet door 12. The body 11 has an opening, and an accommodation cavity R of the body 11 is connected to the opening. The cabinet door 12 is rotatably mounted at the opening of the body 11, and a rotating shaft of the cabinet door 12 is parallel to the vertical direction. The cabinet door 12 may rotate around the rotating shaft to seal the opening of the body 11 or expose the opening. In this case, the cabinet door 12 is opened, and the accommodation cavity R is exposed.

The uninterruptible power supply cabinet 10 includes a power cabinet 2 and a control cabinet 4. For example, the power cabinet 2 includes a first frame 22 and a plurality of power modules 21, and the plurality of power modules 21 are detachably mounted on the power cabinet 2. The control cabinet 4 includes a third frame 42 and a control module 41. The control module 41 is detachably mounted on the control cabinet 4. The uninterruptible power supply cabinet 10 further includes a bypass module 31, where the bypass module 31 is detachably mounted on the first frame 22, and is specifically located above the plurality of power modules 21. A structure of a switch component 51 is not shown in FIG. 24.

With reference to FIG. 9a and FIG. 9b, still refer to FIG. 24. A first power connection end g1 of the cabinet body 1 includes a first mains connection fuse g11, a first battery copper bar g12, a first output connection fuse g13, a first bypass input copper bar g14, and a first bypass output copper bar g15; and a second power connection end g2 on the first frame 22 includes a second mains copper bar g21, a second battery copper bar g22, a second output copper bar g23, a second bypass input copper bar g24, and a second bypass output copper bar g25. As shown in FIG. 24, the second power connection end g1 is located on a top surface of the first frame 22, the second power connection end g1 is a plurality of connectors, and the plurality of connectors are arranged at an edge of the top surface of the first frame 22, to facilitate a connection to the first power connection end g1 of the cabinet body 1, and also facilitate maintenance and replacement. The second bypass input copper bar g24 and the second bypass output copper bar g25 are located at an edge that is on the top surface of the frame and that is connected to a backplane, and the second mains copper bar g21 and the second output copper bar g23 are respectively located at edges that are on the top surface of the frame and that are respectively connected to side walls. A breakpoint D1 between a mains switch and a power module component formed by connecting the plurality of power modules 21 in parallel is formed between the first mains connection fuse g11 and the second mains copper bar g21; a breakpoint D2 between a battery input and the power module component formed by connecting the plurality of power modules 21 in parallel is formed between the first battery copper bar g12 and the second battery copper bar g22; a breakpoint D3 between an output switch and the power module component formed by connecting the plurality of power modules 21 in parallel is formed between the first output connection fuse g13 and the second output copper bar g23; a breakpoint D4 between the bypass module 31 and a bypass switch is formed between the first bypass input copper bar g14 and the second bypass input copper bar g24; and a breakpoint D5 between the bypass module 31 and the output switch is formed between the first bypass output copper bar g15 and the second bypass output copper bar g25.

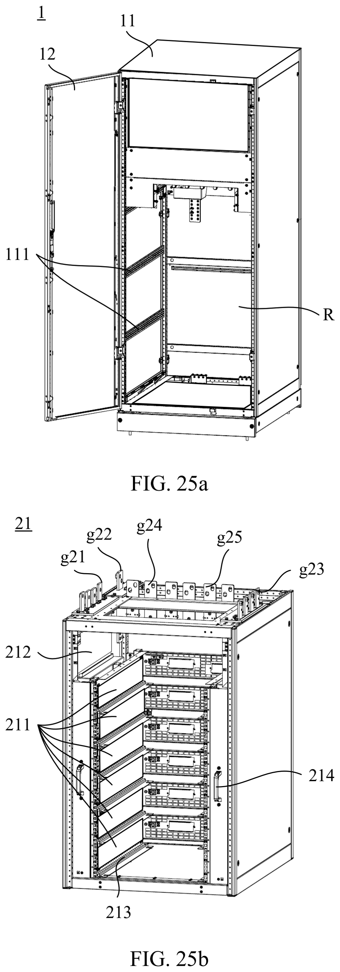

FIG. 25a shows a structure of the cabinet body 1. The body 11 is provided with first slide rails 111 at inner sides of the accommodation cavity R, so that the first frame 22 of the power cabinet 2 can be in sliding fit with the first slide rails 111. When the cabinet door 12 is opened to expose the accommodation cavity R, the first frame 22 can slide out of the accommodation cavity R along the first slide rails 111.

FIG. 25b shows a structure of the first frame 22 of the power cabinet 2. The first frame 22 is of an open box structure, and a plurality of first mounting slots 211 for mounting the power modules 21 and a second mounting slot 212 for mounting the bypass module 31 are disposed in the first frame 22. Second slide rails 213 may be respectively mounted at inner sides of the first mounting slot 211 and the second mounting slot 212, so that the power module 21 and the bypass module 31 can be respectively in sliding fit with corresponding second slide rails 213, to facilitate mounting and removal of the power module 21 and the bypass module 31. The first frame 22 is further provided with a handle 214. When the first frame 22 is mounted in the accommodation cavity R of the cabinet body 1, the handle 214 protrudes from a surface that is of the first frame 22 and that faces the opening of the cabinet body 1. The handle 214 is disposed, so that a worker can apply force to the first frame 22, to pull the first frame 22 out of the accommodation cavity R of the body 11. Two handles 214 are symmetrically disposed on the first frame 22 in a direction perpendicular to the vertical direction, to balance the force.

Still refer to FIG. 25b. For example, the second mains copper bar g21, the second battery copper bar g22, the second output copper bar g23, the second bypass input copper bar g24, and the second bypass output copper bar g25 are disposed at a top of the first frame 22. Types, structures, positions, and quantities of these power distribution devices are merely examples. This is not limited in this application. Specifically, these power distribution devices include but are not limited to a copper bar, a cable, a terminal, a fuse, and the like. When the power cabinet 2 is removed out of the cabinet body, all the power distribution devices may be removed together with the first frame 22, to facilitate maintenance and replacement.

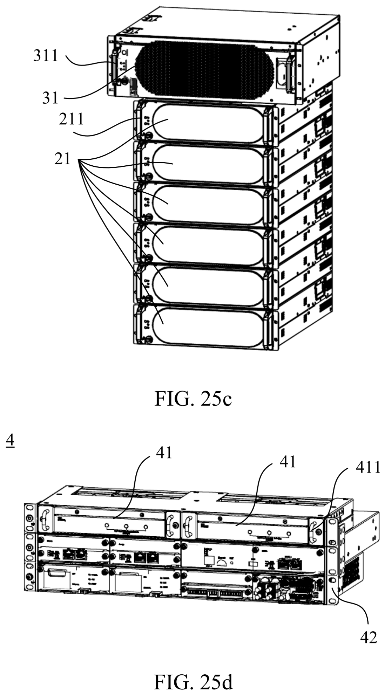

FIG. 25c shows structures of the power module 21 and the bypass module 31. The power module 21 and the bypass module 31 can be detachably mounted on the first frame 22 of the power cabinet 2. When the power module 21 and the bypass module 31 are mounted on the first frame 22, the power module 21 can be electrically connected to the second mains copper bar g21, the second battery copper bar g22, and the second output copper bar g23 on the first frame 22, and the bypass module 31 can be electrically connected to the second bypass input copper bar g24 and the second bypass output copper bar g25 on the first frame 22. A manner of contact between the power module 21 and each power distribution device includes but is not limited to a hot swapping manner, and a manner of contact between the bypass module 31 and each power distribution device includes but is not limited to a hot swapping manner, so that the power module 21 and the bypass module 31 are detachable relative to the first frame 22. For ease of operation by the worker, a first module handle 211 is disposed on a surface that is of the power module 21 and that faces the cabinet door 12, and a second module handle 311 is disposed on a surface that is of the bypass module 31 and that faces the cabinet door 12. For example, two first module handles 211 are symmetrically disposed, and two second module handles 311 are symmetrically disposed.

FIG. 25d shows a structure of the control cabinet 4, and a plurality of control modules 41 may be mounted on the third frame 42 of the control cabinet 4. The control module 41 may also be mounted on the third frame 42 in a hot swapping manner, and a third module handle 411 is disposed on a surface that is of the control module 41 and that faces the cabinet door 12. A manner of a connection between the third frame 42 and the cabinet body 1 may be a port-swappable structure.

In some embodiments, the uninterruptible power supply cabinet 10 may further include a connector adapter, where one end of the connector adapter is configured to detachably and electrically connect to the first power connection end g1, and another end of the connector adapter is configured to detachably and electrically connect to the second power connection end g2. That is, the first power connection end g1 and the second power connection end g2 are connected through the connector adapter. The connector adapter functions as a third-party connector, and may also be detached or replaced. This can further improve maintenance convenience of a system and system reliability.

Based on the uninterruptible power supply cabinets 10 provided in the foregoing embodiments, an embodiment of this application may further provide a power supply system. The power supply system includes any one of the uninterruptible power supply cabinets 10 provided in the foregoing embodiments, and is configured to convert a current input by a power supply and then supply a converted current to a load. The uninterruptible power supply cabinet 10 may be used individually, to be specific, the uninterruptible power supply cabinet 10 may be used individually or a plurality of uninterruptible power supply cabinets may be connected in parallel. When mounted, the uninterruptible power supply cabinet 10 may be mounted against a wall or may not be mounted against the wall.

The uninterruptible power supply cabinet 10 or the power supply system including the uninterruptible power supply cabinet 10 provided in embodiments of this application may be used in an indoor scenario such as a large data center, a large communication center, an equipment room of a large-scale enterprise, an equipment room of a financial system, industrial automated equipment, or a scheduling center.

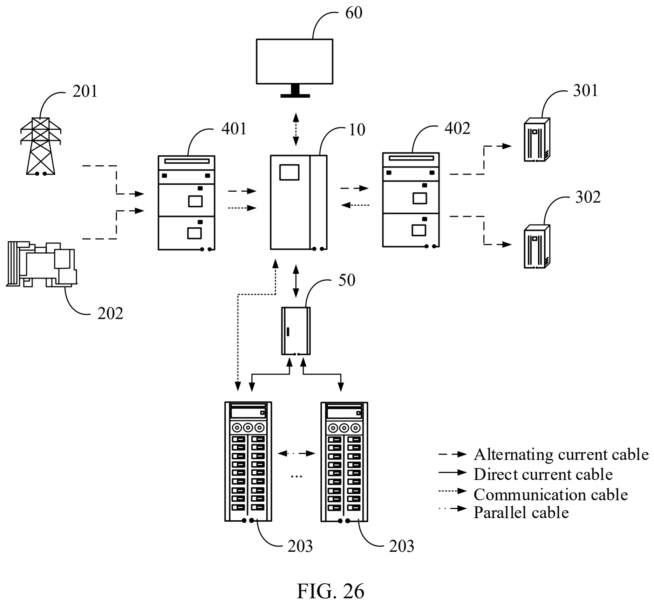

As shown in FIG. 26, an embodiment of this application further provides a data center. The data center includes a power supply, a load, and the foregoing power supply system. As shown in FIG. 26, for example, the data center includes an uninterruptible power supply cabinet 10. The power supply includes a first alternating current input 201, a second alternating current input 202, and a plurality of battery packs 203. The first alternating current input 201 may be a mains supply, the second alternating current input 202 may be a diesel generator, the first alternating current input 201 and the second alternating current input 202 are configured to input alternating currents to the uninterruptible power supply cabinet 10, and a power input cabinet 401 may be disposed between the uninterruptible power supply cabinet 10 and the first alternating current input 201 and the second alternating current input 202. The battery pack 203 is configured to input a direct current to the uninterruptible power supply cabinet 10, and a battery bus bar box 50 may be disposed between the battery pack 203 and the uninterruptible power supply cabinet 10. The uninterruptible power supply cabinet 10 converts the current and then supplies power to a load. The load includes a first user load 301 and a second user load 302, and an output power distribution cabinet 402 may be disposed between the load and the uninterruptible power supply cabinet 10. To facilitate system management, the data center further includes a management system 60, where the management system 60 is signal-connected to the uninterruptible power supply cabinet 10, and the uninterruptible power supply cabinet 10 is signal-connected to the battery pack 203, the power input cabinet 401, and the output power distribution cabinet 402. There are a plurality of battery packs 203, and the plurality of battery packs 203 are signal-connected to each other.

It is clear that persons skilled in the art can make various modifications and variations to this application without departing from the scope of this application. This application is intended to cover these modifications and variations of this application provided that they fall within the scope of protection defined by the claims and their equivalent technologies.

## Claims

1. An uninterruptible power supply cabinet, comprising: a cabinet body, a switch component, and a power cabinet, wherein the power cabinet and the switch component are disposed in the cabinet body;
the cabinet body is provided with an external port and a first power connection end, and the external port is configured to connect to an external device;
one end of the switch component is electrically connected to the external port, and another end of the switch component is electrically connected to the first power connection end; and
the power cabinet comprises a first frame and at least one power module, wherein the first frame comprises a second power connection end, the second power connection end is configured to detachably and electrically connect to the first power connection end, the power module is detachably mounted on the first frame, and the power module is detachably and electrically connected to the second power connection end.

2. The uninterruptible power supply cabinet according to claim 1, wherein the power cabinet comprises a bypass module, wherein the bypass module is detachably mounted on the first frame, and the bypass module is detachably and electrically connected to the second power connection end.

3. The uninterruptible power supply cabinet according to claim 2, wherein the power cabinet comprises a control module, wherein the control module is detachably mounted on the first frame, and the control module is separately signal-connected to the power module and the bypass module.

4. The uninterruptible power supply cabinet according to claim 2, wherein the uninterruptible power supply cabinet comprises a control cabinet, wherein the control cabinet comprises a third frame and a control module, the control module is detachably mounted on the third frame, and the control module is signal-connected to each power module.

5. The uninterruptible power supply cabinet according to claim 1, wherein the uninterruptible power supply cabinet comprises a bypass cabinet, wherein the bypass cabinet comprises a second frame and a bypass module; and
the cabinet body comprises a first bypass connection end, the second frame comprises a second bypass connection end, the second bypass connection end is configured to detachably and electrically connect to the first bypass connection end, the bypass module is detachably mounted on the second frame, and the bypass module is detachably and electrically connected to the second bypass connection end.

6. The uninterruptible power supply cabinet according to claim 5, wherein the bypass cabinet comprises a control module, wherein the control module is detachably mounted on the second frame, and the control module is separately signal-connected to the power module and the bypass module.

7. The uninterruptible power supply cabinet according to claim 6, wherein the first power connection end is fastened to the second frame, the switch component is detachably mounted on the second frame, and the switch component is detachably and electrically connected to the first power connection end;
the cabinet body comprises a first switch connection end and a first flat cable connection end, wherein the first switch connection end is electrically connected to the external port, and the first flat cable connection end is electrically connected to the first power connection end; and
the second frame comprises a second switch connection end, wherein the second switch connection end is configured to detachably and electrically connect to the first switch connection end, and the switch component is detachably and electrically connected to the second switch connection end.

8. The uninterruptible power supply cabinet according to claim 5, wherein the uninterruptible power supply cabinet comprises a control cabinet, wherein the control cabinet comprises a third frame and a control module, the control module is detachably mounted on the third frame, and the control module is signal-connected to each power module.

9. The uninterruptible power supply cabinet according to claim 4 or 8, wherein the first power connection end is fastened to the third frame, the switch component is detachably mounted on the third frame, and the switch component is detachably and electrically connected to the first power connection end;
the cabinet body comprises a first switch connection end and a first flat cable connection end, wherein the first switch connection end is electrically connected to the external port, and the first flat cable connection end is electrically connected to the first power connection end; and
the third frame comprises a second switch connection end, wherein the second switch connection end is configured to detachably and electrically connect to the first switch connection end, and the switch component is detachably and electrically connected to the second switch connection end.

10. The uninterruptible power supply cabinet according to claim 3, 4, 6, or 8, wherein the uninterruptible power supply cabinet comprises a switch cabinet, wherein the switch cabinet comprises a fourth frame, the first power connection end is fastened to the fourth frame, and the switch component is detachably mounted on the fourth frame and is detachably and electrically connected to the first power connection end;
the cabinet body comprises a first switch connection end and a first flat cable connection end, wherein the first switch connection end is electrically connected to the external port, and the first flat cable connection end is electrically connected to the first power connection end; and
the fourth frame comprises a second switch connection end, wherein the second switch connection end is configured to detachably and electrically connect to the first switch connection end, and the switch component is detachably and electrically connected to the second switch connection end.

11. The uninterruptible power supply cabinet according to claim 1, wherein the uninterruptible power supply cabinet comprises a connector adapter, wherein one end of the connector adapter is configured to detachably and electrically connect to the first power connection end, and another end of the connector adapter is configured to detachably and electrically connect to the second power connection end.

12. The uninterruptible power supply cabinet according to claim 1, wherein a manner of a connection between the first power connection end and the second power connection end comprises any one or a combination of more of a copper bar connection, a fuse connection, a cable connection, and a terminal connection.

13. The uninterruptible power supply cabinet according to claim 1, wherein a guide rail is disposed in an accommodation cavity of the cabinet body, and the power cabinet is in sliding fit with the guide rail.

14. The uninterruptible power supply cabinet according to claim 1, wherein a handle is disposed on a surface that is of the first frame and that faces a cabinet door of the cabinet body, and the handle protrudes from the surface that is of the first frame and that faces the cabinet door of the cabinet body.

15. The uninterruptible power supply cabinet according to claim 1, wherein the second power connection end is a plurality of connectors, and the plurality of connectors are arranged at an edge of a top surface of the first frame.
